# FASCICULE DE BREVET EUROPEEN

(11) **EP 4 576 990 B1**
(45) Date de publication et mention de la délivrance du brevet: **09.12.2026**
(21) Numéro de dépôt: 24221277.7
(22) Date de dépôt: 18.12.2024
(51) Int. Cl.: H10D 30/40, H10D 62/10, H10D 64/27, B82Y 10/00

(54) **DISPOSITIF QUANTIQUE A QUBITS EMPILES**
QUANTENVORRICHTUNG MIT GESTAPELTEN QUBITS
QUANTUM DEVICE WITH STACKED QUBITS

(30) Priorité: 22.12.2023 FR 2315156
(43) Date de publication de la demande: 25.06.2025
(73) Titulaire: COMMISSARIAT À L'ÉNERGIE ATOMIQUE ET AUX ÉNERGIES ALTERNATIVES, 75015 Paris (FR)
(72) Inventeur: NIEBOJEWSKI, Heimanu, 38054 GRENOBLE Cedex 09 (FR)
(74) Mandataire: Santarelli

(56) Documents cités:
- WO-A1-2017/213649
- WO-A1-2018/063203
- WO-A1-2019/125348
- US-A1- 2018 277 669
- US-A1- 2020 343 435
- US-A1- 20230 170 402
- US-A1- 20230 197 833

## Description

### DOMAINE TECHNIQUE ET ÉTAT DE LA TECHNIQUE ANTÉRIEURE

La présente demande se rapporte au domaine des dispositifs quantiques dans lesquelles au moins une informatique quantique basée sur un état quantique donné parmi au moins deux niveaux mesurables est utilisée comme vecteur d'information. Cet état quantique est appelé qubit ou bit quantique ou encore « quantum bit » en anglais.

Un type particulier de qubit est le qubit de spin lorsqu'on utilise le degré de liberté intrinsèque du spin d'électrons individuels pour coder l'information quantique.

Les qubits peuvent être formés dans un matériau semi-conducteur au sein de structures de confinement de tailles nanométriques et définies de manière électrostatique et ou physique. Ces structures de confinement sont typiquement appelées « boites quantiques » (« quantum dots » en anglais).

Une boîte quantique se comporte comme un puits de potentiel confinant une ou plusieurs charges élémentaires (électrons ou trous) dans une région de semi-conducteur.

Pour mesurer l'état d'un qubit, il est connu de procéder à une conversion spin/charge qui permet de convertir l'état de spin des particules chargées en un état de charge des boites quantiques contenant lesdites particules. Il est alors nécessaire de mesurer cet état de charge afin d'en déduire l'état de spin des particules chargées avant conversion. Pour cela, un moyen de mesure de l'état de charge est en général disposé en regard ou à proximité de chaque boite quantique.

La lecture d'un qubit peut être en particulier réalisée en utilisant une autre boîte quantique appelée « ilot de lecture » ou « ilot de détection » couplée à celle du qubit destiné à être lu. Ces deux éléments forment deux puits de potentiel séparés par une barrière de potentiel.

Des dispositifs dans lesquels les ilots de détection et boites quantiques sont disposées en regard et dans un même plan parallèle au plan principal d'un substrat sur lequel les boites quantiques et les ilots de détection sont formées, sont connus.

Le document de R Pillarisetty "High Volume Electrical Characterization of Semiconductor Qubits", 2019 IEEE International Electron Devices Meeting (IEDM) propose par exemple un dispositif avec des boites quantiques formées dans un premier bloc semi-conducteur de forme allongée (« fin » selon la terminologie anglo-saxonne ») et des ilots de détection formées dans un deuxième bloc semi-conducteur de forme allongée et parallèle au premier bloc.

Le document US 2018/277669 A1 divulgue un dispositif semi-conducteur comprenant deux transistors à électron unique, chacun comprenant une région d'îlot constituant une région semi-conductrice, une région source/drain inférieure disposée sous la région d'îlot, une région source/drain supérieure disposée au-dessus de la région d'îlot et une structure de grille disposée sur un côté de la région d'îlot.

Le document US 2023/197833 A1 divulgue un dispositif à boîtes quantiques comprenant un premier nanoruban et un second nanoruban s'étendant sensiblement parallèlement à un substrat de support. Une première électrode de grille entoure partiellement une partie du premier nanoruban, et une seconde électrode de grille entoure partiellement une partie du second nanoruban. Les parties des premier et second nanorubans qui ne sont pas recouvertes par les électrodes de grille respectives sont disposées de manière à se faire face selon une direction verticale, ladite direction verticale étant perpendiculaire au plan du substrat de support. Les premier et second nanorubans, ainsi que les première et seconde électrodes de grille, sont noyés dans une couche diélectrique disposée sur le substrat de support.

Des dispositifs quantiques sont également connus des documents WO 2019/125348 A1, WO 2018/063203 A1, WO 2017/213649 A1, US 2020/343435 A1 et US 2023/170402 A1.

Il se pose le problème de réaliser un nouveau dispositif quantique et qui soit de préférence amélioré en termes de densité d'intégration tout en conservant une bonne sensibilité de détection.

### EXPOSÉ DE L'INVENTION

Selon un aspect, la présente invention concerne un dispositif électronique quantique selon la revendication 1, ledit dispositif électronique quantique étant doté d'un substrat, le substrat étant revêtu :
- d'un premier ensemble de régions semi-conductrices comprenant au moins une première région semi-conductrice inférieure et au moins une première région semi-conducteur supérieure, superposée à, et séparée de, la première région semi-conductrice inférieure par le biais d'une première zone dite « de séparation », en matériau diélectrique,
- d'un deuxième ensemble de régions semi-conductrices comprenant au moins une deuxième région semi-conductrice inférieure et au moins une deuxième région semi-conducteur supérieure, superposée à, et séparée de, la deuxième région semi-conductrice inférieure par le biais d'une deuxième zone dite « de séparation » en matériau diélectrique,
le premier ensemble de régions semi-conductrices étant disposé en vis-à-vis du deuxième ensemble de régions semi-conductrices de sorte que la première région semi-conductrice inférieure est disposée en regard de la deuxième région semi-conductrice inférieure et de sorte que la première région semi-conductrice supérieure est disposée en regard de la deuxième région semi-conductrice supérieure,
- au moins une région diélectrique séparant le premier ensemble de régions semi-conductrices du deuxième ensemble de régions semi-conductrices.

Selon l'invention, la région diélectrique est prévue de sorte à permettre un couplage électrostatique entre la première région semi-conductrice inférieure et la deuxième région semi-conductrice inférieure, et de sorte à permettre un couplage électrostatique entre la première région semi-conductrice supérieure et la deuxième région semi-conductrice supérieure,

En combinaison, les zones de séparation peuvent être également prévues de sorte à permettre un couplage électrostatique entre la première région semi-conductrice inférieure et la première région semi-conductrice supérieure, et de sorte à permettre un couplage électrostatique entre la deuxième région semi-conductrice inférieure et la deuxième région semi-conductrice supérieure.

Avec un tel dispositif on obtient une densité de qubits améliorée tout en permettant de préserver une proximité entre boite quantique et ilot de détection permettant de conserver une bonne sensibilité de détection.

Selon l'invention le dispositif électronique quantique comprend:
- un premier groupe de grilles superposées comprenant au moins une première grille inférieure et une première grille supérieure superposée à, et séparée de la première grille inférieure par le biais d'une première zone d'isolation, la première grille inférieure et la première grille supérieure étant disposées contre, et en regard, respectivement de la première région semi-conductrice inférieure et de la première région semi-conductrice supérieure de sorte à exercer respectivement un contrôle électrostatique de la première région semi-conductrice inférieure et de la première région semi-conductrice supérieure,
- un deuxième groupe de grilles superposées comprenant au moins une deuxième grille inférieure séparée d'une deuxième grille supérieure superposée à, et séparée de la deuxième grille inférieure par le biais d'une deuxième zone d'isolation, la deuxième grille inférieure et la deuxième grille supérieure étant disposées contre, et en regard, respectivement de la deuxième région semi-conductrice inférieure et de la deuxième région semi-conductrice supérieure de sorte à exercer respectivement un contrôle électrostatique de la deuxième région semi-conductrice inférieure et de la deuxième région semi-conductrice supérieure, le premier groupe de grilles superposées et le deuxième groupe de grille superposées étant disposés de part et d'autre du premier ensemble de régions semi-conductrices et du deuxième ensemble de régions semi-conductrices.

Selon l'invention, les régions semi-conductrices inférieures sont agencées dans un même premier plan, tandis que les régions semi-conductrices supérieures sont agencées dans un même deuxième plan, les premier et deuxième plans étant parallèles à un plan principal du substrat.

Avantageusement, la première région semi-conductrice inférieure et la première région semi-conductrice supérieure sont des régions respectivement d'un barreau semi-conducteur inférieur et d'un barreau semi-conducteur supérieur, le barreau semi-conducteur inférieur et le barreau semi-conducteur supérieur s'étendant parallèlement à une première direction parallèle au plan principal du substrat, le dispositif étant doté d'un troisième groupe de grilles superposées juxtaposé audit premier groupe de grilles superposées et dédiées au contrôle électrostatique d'une troisième région semi-conductrice inférieure du barreau semi-conducteur inférieur et d'une troisième région semi-conductrice supérieure du barreau semi-conducteur supérieur.

Selon une possibilité de mise en œuvre, ledit barreau semi-conducteur inférieur et ledit barreau semi-conducteur supérieur, sont respectivement un premier barreau semi-conducteur inférieur et un premier barreau semi-conducteur supérieur, la deuxième région semi-conductrice inférieure et la deuxième région semi-conductrice supérieure étant des régions respectivement d'un deuxième barreau semi-conducteur inférieur et d'un deuxième barreau semi-conducteur supérieur, lesdits deuxièmes barreau semi-conducteur inférieur et supérieur s'étendant parallèlement respectivement auxdits premier barreau semi-conducteur inférieur et supérieur, le dispositif étant doté d'un quatrième groupe de grilles superposées juxtaposé audit deuxième groupe de grilles superposées pour le contrôle électrostatique d'une quatrième région semi-conductrice du deuxième barreau semi-conducteur inférieur et d'une quatrième région semi-conductrice supérieure du deuxième barreau semi-conducteur supérieur, le premier barreau semi-conducteur inférieur et le deuxième barreau semi-conducteur inférieur étant situés dans le premier plan parallèle au plan principal du substrat, le premier barreau semi-conducteur supérieur et le deuxième barreau semi-conducteur supérieur étant situés dans le deuxième plan parallèle au plan principal du substrat, la troisième région semi-conductrice inférieure étant disposée en regard de la quatrième région inférieure, la troisième région semi-conductrice supérieure étant disposée en regard de la quatrième région semi-conductrice supérieure.

Selon une possibilité de mise en œuvre, le dispositif peut comprendre en outre, dans une direction parallèle à la première direction, entre ledit premier groupe de grilles et ledit troisième groupe de grille :
- au moins une électrode d'échange ou,
- des électrodes d'échanges superposées et séparées l'une de l'autre par une couche de séparation isolante,
- une zone d'au moins un matériau isolant.

Selon un mode de réalisation avantageux, le dispositif peut comprendre en outre :
- un bloc semi-conducteur dopé, formant un premier réservoir de dopants, le bloc semi-conducteur dopé étant agencé à une première extrémité du premier barreau semi-conducteur supérieur, du premier barreau semi-conducteur inférieur, du deuxième barreau semi-conducteur supérieur, du deuxième barreau semi-conducteur inférieur,
- un autre bloc semi-conducteur dopé, formant un deuxième réservoir de dopants, l'autre bloc semi-conducteur dopé étant agencé à une deuxième extrémité du premier barreau semi-conducteur supérieur, du premier barreau semi-conducteur inférieur, du deuxième barreau semi-conducteur supérieur, du deuxième barreau semi-conducteur inférieur, et qui est opposée à la première extrémité.

Selon un mode de réalisation particulier, la région diélectrique entre le premier ensemble de régions semi-conductrices et le deuxième ensemble de régions semi-conductrices est prévue avec une composition diélectrique hétérogène de sorte que dans une portion centrale située entre la première région semi-conductrice inférieure et la deuxième région semi-conductrice supérieure et entre la première région semi-conductrice supérieure et la deuxième région semi-conductrice inférieure, la région diélectrique a une première composition et une première permittivité diélectrique relative, et que dans une autre portion située entre la première région semi-conductrice inférieure et la deuxième région semi-conductrice inférieure ou entre la première région semi-conductrice supérieure et la deuxième région semi-conductrice supérieure, la région diélectrique a une deuxième composition et une deuxième permittivité diélectrique relative plus élevée que la première permittivité diélectrique relative.

Selon une première possibilité d'agencement de ce mode de réalisation particulier, la région diélectrique à composition diélectrique hétérogène entre le premier ensemble et le deuxième ensemble de régions semi-conductrices peut être formée :
- de ladite portion centrale en un premier matériau diélectrique ayant une première constante diélectrique,
- d'une portion inférieure située entre la première région semi-conductrice inférieure et la deuxième région semi-conductrice inférieure en un deuxième matériau diélectrique ayant une deuxième constante diélectrique inférieure à la première constante diélectrique,
- d'une portion supérieure située entre la première région semi-conductrice supérieure et la deuxième région semi-conductrice supérieure en un deuxième matériau diélectrique ayant une deuxième constante diélectrique inférieure à la première constante diélectrique, la portion inférieure, la portion centrale et la portion supérieure étant superposées.

Selon une deuxième possibilité d'agencement de ce mode de réalisation particulier, la région diélectrique à composition isolante hétérogène entre le premier ensemble et le deuxième ensemble de régions semi-conductrices est formée :
- d'au moins un matériau diélectrique ayant un constante diélectrique k2 enrobant chacune des premières et deuxièmes régions semi-conductrices inférieure et supérieure, de sorte à former des bosses isolantes inférieures contre les premières et deuxièmes régions semi-conductrices inférieure et des bosses supérieures contre les premières et deuxièmes régions semi-conductrices supérieures, et des parties creuses chacune entre une bosse isolante supérieure située sur la première ou deuxième région semi-conductrice supérieure une bosse isolante inférieure située sur la première ou deuxième région semi-conductrice inférieure.
- d'un espace isolant agencé formé entre les bosses isolantes et par les parties creuses, ledit espace isolant étant comblé par un autre matériau diélectrique ayant un constante diélectrique k1, telle que k1 < k2, ou étant vide.

Selon un autre aspect, la présente invention concerne un procédé de réalisation d'un dispositif électronique quantique selon la revendication 8.

Un mode de réalisation prévoit un procédé de fabrication d'un dispositif quantique selon l'invention, tel que défini plus haut et dans lequel la formation du premier ensemble de régions semi-conductrices et dudit deuxième ensemble de régions semi-conductrices comprend des étapes de :
- réalisation sur ledit substrat d'une structure formé d'une superposition de couches composée d'une alternance de couches à base d'un premier matériau donné, et de couches à base d'un deuxième matériau, le deuxième matériau étant semi-conducteur, ledit premier matériau donné étant apte à être gravé sélectivement vis-à-vis dudit deuxième matériau donné,
- réalisation d'une tranchée de séparation s'étendant principalement dans une direction parallèle à la première direction par gravure de ladite superposition de couches de sorte à de sorte à diviser ladite structure en une première portion et une deuxième portion, la première portion et la deuxième portion s'étendant parallèlement à la première direction, les régions semi-conductrices dudit premier ensemble étant des régions semi-conductrices de la première portion et formées à base dudit deuxième matériau donné, les régions semi-conductrices dudit deuxième ensemble étant des régions semi-conductrices de la deuxième portion et formées à base dudit deuxième matériau donné.

Avantageusement, après la réalisation de ladite tranchée, le procédé peut comprendre la formation de ladite région diélectrique par dépôt de matériau diélectrique entre ladite première portion et ladite deuxième portion de ladite structure.

Selon une possibilité de mise en œuvre, après réalisation de la tranchée de séparation et préalablement à la formation de ladite région diélectrique, le procédé peut comprendre des étapes de :
- gravure au moins partielle dudit premier matériau donné et sélective vis-à-vis du deuxième matériau dans la première portion et ladite deuxième portion de sorte à libérer des espaces,
- remplissage desdits espaces par un matériau diélectrique de sorte à former la première zone « de séparation » et la deuxième zone « de séparation ».

Selon un mode de réalisation, après avoir rempli lesdits espaces par un matériau diélectrique donné, le procédé peut comprendre des étapes de :
- gravure anisotrope du matériau diélectrique de sorte à libérer un espace formant une tranchée réduite entre lesdites portions de zone active,
- remplissage de la tranchée réduite au moyen d'au moins un autre matériau diélectrique différent dudit matériau diélectrique donné.

Avantageusement, le procédé de fabrication du dispositif quantique peut comprendre en outre, après formation de ladite structure et préalablement à la formation de ladite tranchée de séparation dans cette structure, des étapes de :
- formation de motifs de grille en matériau de grille de part et d'autre de la structure,
- formation d'une encapsulation isolante autour des motifs de grille,
- retrait partiel du matériau de grille de sorte à conserver un bloc inférieur (GI) de matériau de grille et réaliser des cavités au-dessus de ce bloc inférieur de matériau de grille et entourées par l'encapsulation,
- remplir les cavités d'au moins une couche isolante de sorte à former une zone d'isolation sur le bloc inférieur de matériau de grille puis,
- remplir les cavités d'au moins une couche de matériau de grille, de sorte à former un bloc supérieur de matériau de grille sur la zone d'isolation.

De manière avantageuse, le procédé de fabrication peut comprendre en outre,
après formation de ladite structure et préalablement à la formation de ladite tranchée de séparation dans cette structure, une formation de réservoirs de dopants à des extrémités de ladite structure, la formation desdits réservoirs de dopants comprenant :
- réaliser une gravure sélective partielle du premier matériau vis-à-vis du deuxième matériau afin de créer des renfoncements au niveau desdites extrémités de ladite structure,
- combler lesdits renfoncements par un matériau isolant afin de former des bouchons isolants dans lesdits renfoncements,
- réaliser une épitaxie de matériau semi-conducteur à partir d'extrémités dévoilées des couches à base du deuxième matériau, tandis que les couches à base du premier matériau sont protégées par les bouchons isolants.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
La figure 1 illustre un exemple de dispositif quantique suivant l'invention à plusieurs niveaux de régions semi-conductrices superposées.
La figure 2A illustre un exemple de réalisation dans lequel le dispositif quantique est doté de plusieurs paires de grille superposées et réparties le long de barreaux semi-conducteurs superposés.
La figure 2B illustre une superposition de barreaux semi-conducteur dans le dispositif quantique.
Les figures 3 et 4 illustrent un exemple réalisation du dispositif quantique dans lequel un espace isolant est prévu entre des groupes de grilles voisins et répartis le long de barreaux semi-conducteurs superposés.
Les figures 5, 6A et 6B illustrent un exemple de réalisation d'une structure semi-conductrice de zone active pour dispositif quantique à deux ensembles de régions semi-conductrices superposées.
Les figures 7, 8 et 9 illustrent un exemple de réalisation de motifs de grilles.
Les figures 10 à 13 illustrent un exemple de réalisation de réservoirs de dopants.
Les figure 14 19B illustrent un exemple de réalisation de grilles superposées à partir des motifs de grille.
Ls figures 20A et 20B illustrent un exemple de réalisation d'une tranchée de séparation pour séparer une structure semi-conductrice de zone active en portions distinctes et agencées face à face l'une de l'autre et comportant des régions semi-conductrices superposées.
Les figures 21 et 22 illustrent un exemple de réalisation de zones de séparation diélectriques intercalées entre des régions semi-conductrices superposées des portions de la structure de zone active.
Les figures 23A et 23B illustrent un exemple de réalisation d'une région diélectrique intermédiaire entre une première portion et une deuxième portion de structure de zone active.
La figure 24 illustre un premier mode de réalisation particulier du dispositif quantique dans lequel la région diélectrique intermédiaire a une composition hétérogène afin de permettre un couplage électrostatique entre régions semi-conductrices de la première portion et de la deuxième portion situées dans un même niveau tout en empêchant un couplage électrostatique entre d'une part des régions semi-conductrices de la première portion et d'autre part des régions semi-conductrices de la deuxième portion situées dans des niveaux différents.
Les figures 25 à 29 illustrent un exemple de procédé de fabrication du premier mode de réalisation particulier de dispositif quantique.
Les figures 30 à 40 illustrent un deuxième mode de réalisation particulier du dispositif quantique.
Les figures 32, 33 et 34 illustrent un premier exemple de procédé de fabrication du deuxième exemple de réalisation particulier de dispositif quantique.
Les figures 36 à 39 illustrent un exemple de procédé de fabrication du deuxième mode de réalisation particulier du dispositif quantique.
Les figure 41 et 42 illustrent un exemple de réalisation de grilles d'échange.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « dessus », « dessous », « inférieur », « supérieur », « juxtaposé », « superposé » s'appliquent en considérant que la structure est orientée de la façon illustrée sur les figures.

### EXPOSÉ DÉTAILLÉ DE MODES DE RÉALISATION PARTICULIERS

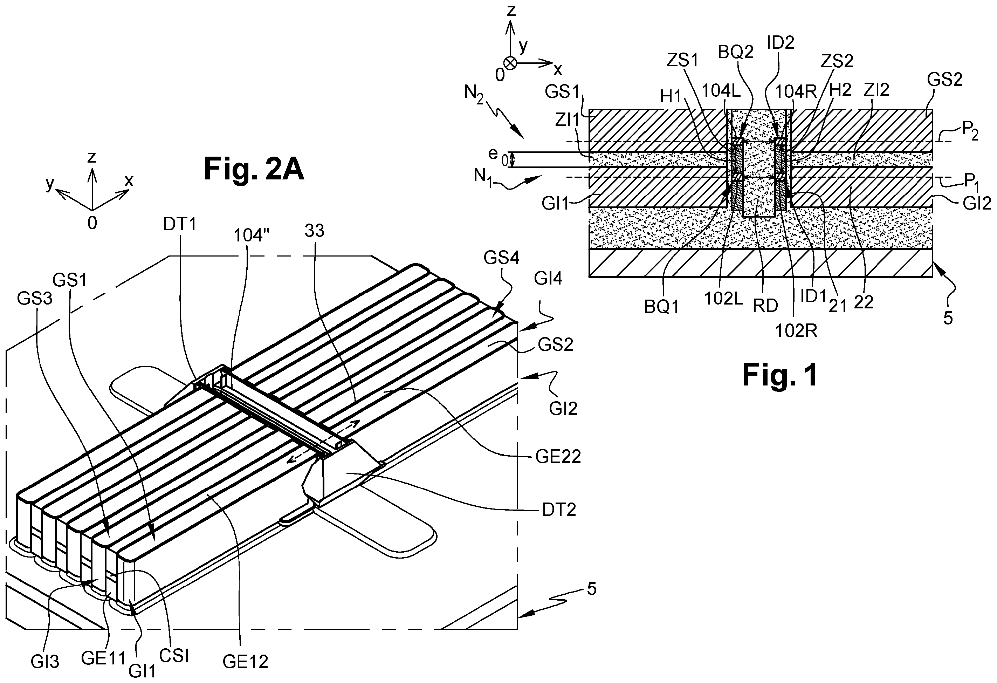

On se réfère tout d'abord à la figure 1 qui donne un exemple de réalisation d'un dispositif quantique.

Le dispositif est agencé sur un substrat 5 qui peut être par exemple de type semi-conducteur sur isolant, en particulier de type SOI (SOI pour « Silicon On Insulator » ou silicium sur isolant) ou bien de type massif (« bulk » selon la terminologie anglosaxonne), par exemple en silicium.

Le dispositif est doté ici de boites quantiques BQ1, BQ2 formées dans un premier ensemble de régions semi-conductrices superposées 102L, 104L, par exemple en silicium ou en germanium. Une boite quantique BQ1 est ainsi réalisée dans une première région semi-conductrice 102L dite « inférieure » tandis qu'une autre boite quantique BQ2 disposée au-dessus de la première région semi-conductrice inférieure, est formée dans une première région semi-conductrice dite « supérieure » 104L.

Les boites quantiques BQ1, BQ2 assurent chacune le confinement d'au moins une charge élémentaire (électron(s) ou trou(s)). De préférence, chaque boite quantique BQ1, BQ2 comporte ici une seule charge élémentaire. Le spin de cette charge, en particulier un électron, peut être prévu pour coder l'information quantique. Dans ce cas, les qubits associés aux boites quantiques BQ1, BQ2 sont des qubit de spin.

Pour permettre de détecter un état quantique également appelé « état de charge » des boites quantique BQ1, BQ2, une structure de détection de charge est prévue à proximité et dans cet exemple en face des boites quantiques BQ1, BQ2.

Cette structure de détection comprend des ilots de détection ID1, ID2 formés dans un deuxième ensemble de régions semi-conductrices superposées 102R, 104R, typiquement à base d'un même matériau semi-conducteur que les régions 102L, 104L. Un ilot de détection ID1 est ainsi réalisé dans une deuxième région semi-conductrice inférieure 102R qui fait face à la première région semi-conductrice inférieure 102L tandis qu'un autre ilot de détection ID2 est formé dans une deuxième région semi-conductrice supérieure 104R disposée au-dessus de la deuxième région semi-conductrice inférieure 102R et fait face à la première région semi-conductrice supérieure 104L.

Les premières régions semi-conductrices 102L, 104L sont ainsi ici prévues pour former chacune un qubit, tandis que les deuxièmes régions semi-conductrices 102R, 104R sont ici dédiées à la lecture des qubits.

Selon l'invention, les régions semi-conductrices inférieures 102L, 102R sont agencées dans un même premier plan P1, tandis que les régions semi-conductrices supérieures 104L, 104R sont agencées dans un même deuxième plan P2, les premier et deuxième plans P1 et P2 étant parallèles à un plan principal du substrat 5 (i.e. un plan défini tout au long de la description comme un plan passant par le substrat 5 et qui est parallèle au plan [0 ;x ;y] du repère orthogonal [0 ;x ;y ;°z]).

Le dispositif est pourvu également d'au moins une région diélectrique RD à base d'au moins un matériau diélectrique située entre d'une part la superposition de boites quantiques BQ1, BQ2 et d'autre part la superposition d'ilots ID1, ID2.

Dans cet exemple de réalisation, le fonctionnement du dispositif repose sur un couplage capacitif également appelé « couplage électrostatique » entre chaque boite quantique BQ1, BQ2 et un ilot de détection ID1, ID2 agencé en face de la boite quantique BQ1, BQ2. On choisit dans ce cas le ou les matériau(x) diélectrique(s) de la région diélectrique RD en particulier en termes de permittivité relative ou de constante diélectrique et les dimensions D1, D2 (correspondant respectivement à la distance entre régions semi-conductrices supérieure et à la distance entre régions semi-conductrices inférieures) de cette région diélectrique RD pour permettre d'obtenir un tel couplage électrostatique. Un tel couplage peut se traduire par signal utile mesurable supérieur à un signal parasite et qui peut être de l'ordre de plusieurs fF (femto Farad).

Par exemple, pour permettre d'obtenir un couplage électrostatique entre une boite quantique et un ilot en face de cette boite, la région diélectrique RD peut être formée à base de SiO₂, SiN, Al₂O₃, HfO₂, et des dimensions D1, D2 comprises par exemple entre 10 nm et 60 nm, avantageusement entre 20 nm et 40 nm.

Pour permettre de réaliser un contrôle électrostatique des boites quantiques et ilots de détection, on prévoit des grilles formées d'un bloc conducteur ou semi-conducteur en matériau 22 de grille, par exemple du polysilicium, contre une couche diélectrique 21 de grille disposée entre le bloc de grille et les régions semi-conductrices. L'agencement proposé sur la figure 1 a ici pour particularité de prévoir une même couche de diélectrique 21 de grille commune aux deux grilles GI1, GS1 et régions semi-conductrices 102L, 104L superposées.

Les boites quantiques BQ1, BQ2, sont contrôlées par un premier groupe de grilles GI1, GS1 superposées, chaque grille GI1, GS1 étant ici disposée contre un boite quantique BQ1, BQ2. Une première grille dite « inférieure » GI1 pour le contrôle électrostatique de la première région semi-conductrice inférieure 102L est située dans le premier plan P1, tandis qu'une première grille dite « supérieure » GS1 pour le contrôle électrostatique de la première région semi-conductrice supérieure 104L est située dans le deuxième plan P2.

La première grille supérieure GS1 est superposée à, et séparée de la première grille inférieure GI1 par le biais d'une première zone d'isolation ZI1. Cette première zone d'isolation ZI1 des grilles inférieure GI1 et supérieure GS1 entre elles est typiquement en matériau isolant et de préférence d'épaisseur e₀ suffisante pour isoler électriquement les grilles GI1, GS1 l'une de l'autre. Par exemple, la première zone d'isolation ZI1 est formée à base de SiO₂ et a une épaisseur e₀ qui peut être comprise par exemple entre 5 nm et 20 nm.

Pour permettre de réaliser un contrôle électrostatique des régions semi-conductrices 102R, 104R, un deuxième groupe de grilles GI2, GS2 superposées est prévu, chaque grille GI2, GS2 étant ici juxtaposée contre une région semi-conductrice 124a, 124b. Une deuxième grille inférieure GI2 est située dans le premier plan P1, tandis qu'une deuxième grille supérieure GS2 est située dans le deuxième plan P2 et isolée de la grille inférieure GS2 par le biais d'une zone d'isolation ZI2. Cette deuxième zone d'isolation ZI2 des grilles inférieure GI2 et supérieure GS2 est avantageusement prévue avec une épaisseur et un matériau semblables à celle de la première zone d'isolation ZI1.

Dans cet exemple de réalisation, on a ainsi avantageusement un alignement des grilles GS1, GR1 inférieures et des régions semi-conductrices inférieures 102L, 102R dans un même plan P1 et un alignement des grilles GS2, GR2 supérieures et des régions semi-conductrices supérieures 104L, 104R dans un même plan P2 supérieur distinct du plan P1.

Selon une possibilité de mise en œuvre du dispositif, on peut prévoir que chaque étage de qubit est indépendant des autres étages et prévoir ainsi d'empêcher un couplage électrostatique entre la première région semi-conductrice inférieure 102L et la première région semi-conductrice supérieure 104L. Un couplage électrostatique entre la deuxième région semi-conductrice inférieure 102R et la deuxième région semi-conductrice supérieure 104R est alors également typiquement empêché. Dans ce cas, on favorise uniquement des interactions horizontales (autrement dit dans des directions parallèles au plan principal du substrat) entre boite quantiques BQ1, BQ2 et ilots de détections ID1, ID2.

Pour permettre d'isoler l'étage inférieur de l'étage supérieur des zones dites « de séparation » ZS1, ZS2 en matériau diélectrique agencées respectivement entre les premières région semi-conductrices inférieure et supérieure 102L et 104L et entre les deuxièmes région semi-conductrices inférieure et supérieure 102R et 104R sont prévues, par exemple du SiO₂ et avec une épaisseur (également appelée hauteur) H1, H2 suffisante, par exemple d'au moins 30 nm, et typiquement comprise entre 30 nm et 100 nm.

On peut prévoit d'intégrer plusieurs autres boites quantiques dans l'étage inférieur N₁ dans lequel se situe la boite quantique BQ1 et plusieurs autres boites quantiques dans l'étage supérieur N₂ dans lequel se situe la boite quantique BQ2. Dans ce cas, la première région semi-conductrice inférieure 102L peut être une région d'un bloc semi-conducteur typiquement sous forme d'un barreau (vu en coupe sur la figure 1), par exemple de forme parallélépipédique ou sensiblement parallélépipédique et appelé premier barreau semi-conducteur inférieur, dans lequel d'autres régions semi-conductrices formant d'autres boites quantiques contrôlées chacune par une grille sont agencées.

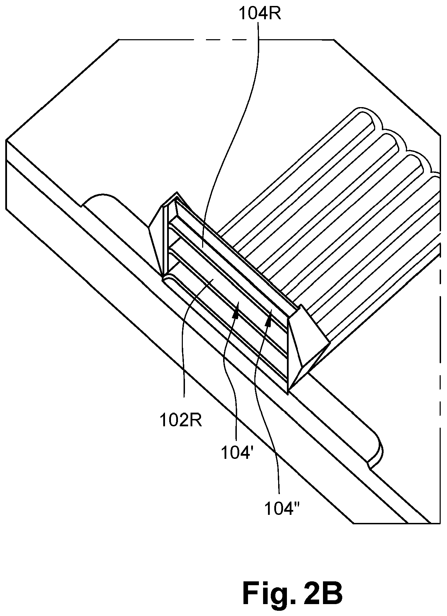

De même, la première région semi-conductrice supérieure 104L peut être formée dans un autre barreau semi-conducteur dit premier barreau semi-conducteur supérieur dans lequel d'autres régions semi-conductrices forment d'autres boites quantiques contrôlées chacune par une grille sont agencées. La deuxième région semi-conductrice inférieure 102R peut être une région d'un deuxième barreau semi-conducteur inférieur situé dans le même premier plan P1 que le premier barreau semi-conducteur inférieur et dans lequel d'autres régions semi-conductrices formant d'autres ilots de détection contrôlés chacun par une grille sont agencées. De même, la deuxième région semi-conductrice supérieure 104R peut être formée dans un deuxième barreau semi-conducteur supérieur dans lequel d'autres régions semi-conductrices forment d'autres ilots de détection contrôlés chacune par une grille sont disposées. Une vue en perspective partielle donnée sur la figure 2B sert à illustrer une superposition de barreaux 104', 104" dans lesquels sont formées respectivement la deuxième région semi-conductrice supérieure 104R et la deuxième région semi-conductrice inférieure 102R.

Les premiers et deuxième barreaux semi-conducteurs inférieur et supérieur s'étendent tous dans une première direction (direction orthogonale au plan de la figure 1 et parallèle à l'axe y du repère orthogonal [0 ;x ;y ;°z]).

Comme on peut le voir dans l'exemple de réalisation illustré sur la figure 2A (où la région diélectrique RD n'est pas représentée pour plus de lisibilité et où seul le deuxième barreau supérieur 104" est visible) d'autres groupes de grilles superposées peuvent être prévues pour contrôler une rangée inférieure et supérieure de boites quantiques ainsi qu'une rangée inférieure et supérieure d'ilots de détection. Les différents groupes de grilles sont répartis dans la première direction le long des barreaux et les grilles s'étendent typiquement dans une deuxième direction orthogonale à la première direction (et parallèle à l'axe x du repère orthogonal [0 ;x ;y ;°z]).

Des grilles GI3, GS3, d'un troisième groupe de grilles superposées, juxtaposé au premier groupe de grilles superposées GI1, GS1 (figure 2A) sont ainsi dédiées au contrôle électrostatique respectivement, d'une troisième région semi-conductrice inférieure du premier barreau semi-conducteur inférieur et, d'une troisième région semi-conductrice supérieure du premier barreau semi-conducteur supérieur. Un quatrième groupe de grilles superposées GI4, GS4 juxtaposé au deuxième groupe de grilles superposées GI2, GS2 est ici également prévu, pour contrôler respectivement une quatrième région semi-conductrice inférieure du deuxième barreau semi-conducteur inférieur et une quatrième région semi-conductrice supérieure du deuxième barreau semi-conducteur supérieur.

De manière avantageuse, le dispositif peut être muni en outre de réservoirs de dopants DT1 et DT2 aux extrémités des rangées inférieure et supérieure de boites quantiques et d'ilots de détection. Ces réservoirs de dopants peuvent être sous forme de blocs, typiquement en matériau semi-conducteur dopé, par exemple du silicium dopé au Phosphore ou du silicium germanium dopé au Bore. Dans l'exemple de réalisation particulier illustré, chaque bloc formant un réservoir dopant DT1, DT2 est relié à une extrémité de l'ensemble des barreaux semi-conducteurs.

De manière avantageuse, des électrodes d'échange GE11, GE12, GE22 également appelées « grilles d'échange » peuvent être prévues dans des espaces inter-grilles. Dans l'exemple de réalisation particulier de la figure 2A, plutôt qu'une seule électrode d'échange dans un même espace inter-grille on prévoit avantageusement une paire d'électrodes d'échange GE11, GE12 superposées dans un même espace inter-grille.

Les électrodes d'échange GE11, GE12 s'étendent principalement dans une direction parallèle à celle dans laquelle les grilles GI1, GS1, GI3, GS3 s'étendent et qui est de préférence orthogonale à la première direction (la première direction étant parallèle à l'axe y) autrement dit à la direction dans laquelle les barreaux semi-conducteur d'accueil des ilots de détection et des boites quantique s'étendent. Chaque électrode d'échange est typiquement séparée des grilles adjacentes par le biais d'une couche isolante d'espaceur 33.

L'agencement des électrodes d'échange GE11, GE12 peut être semblable à celui des grilles GS3, GI3 ou GS1, GI1, de sorte qu'une électrode d'échange supérieure GE12 est disposée au-dessus d'une électrode d'échange inférieure GE11 et isolée de cette électrode d'échange inférieure GE11 par la couche isolante une couche de séparation isolante CSI. Les électrodes d'échanges permettent de réaliser des échanges de charges entre boites quantiques voisines ou entre ilots de détection voisins et répartis le long d'un même barreau semi-conducteur. Ainsi l'électrode d'échange GE11 permet un échange de charges entre une première région semi-conductrice inférieure contrôlée par la grille GI1 et une région semi-conductrice inférieure contrôlée par la grille GI3 et située sur un même barreau semi-conducteur que la première région semi-conductrice inférieure.

La mise en œuvre d'électrodes d'échange est optionnelle, en particulier lorsque le pas Δ de répartition des grilles (« pitch selon la terminologie anglo-saxonne ») est faible et par exemple inférieur à 40 nm. Dans ce cas, ce sont certaines des grilles qui peuvent-être utilisées pour contrôler l'échange entre des boites quantiques ou ilots de détection adjacents d'une même portion semi-conductrice.

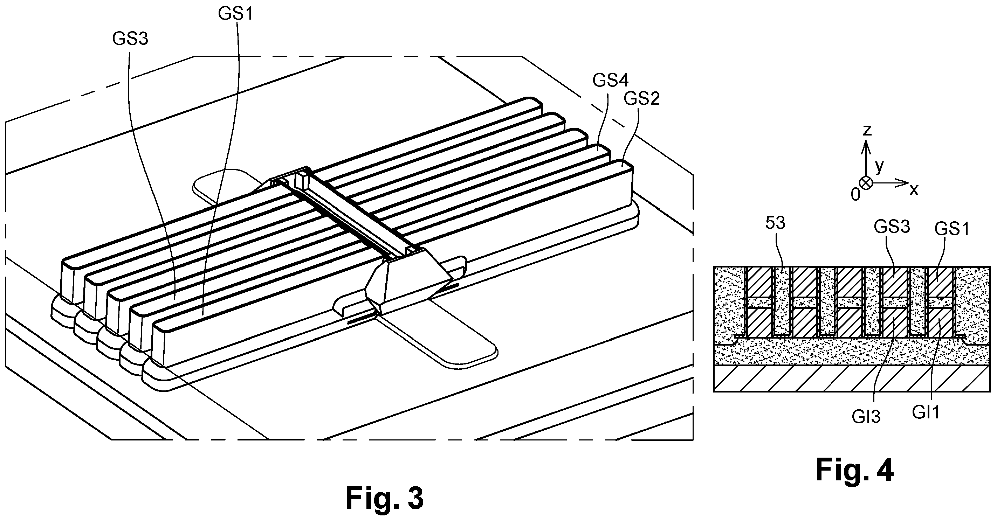

Ainsi, dans une variante de réalisation illustrée sur les figures 3 et 4, les espaces inter-grilles sont dépourvus d'électrode d'échange.

Sur la figure 4 donnant une vue en coupe transversale des grilles GI1, GS1, GI3, GS3 (autrement dit selon un plan de coupe orthogonal à la direction dans laquelle les grilles s'étendent) les espaces inter-grilles sont remplis de matériau isolant 53.

Dans l'un ou l'autre des exemples de réalisation qui viennent d'être donnés, le dispositif comprend deux niveaux ou étages N1, N2 de boites quantiques et d'ilots de détection. Toutefois, le dispositif quantique n'est pas limité à ce nombre et peut intégrer un nombre k (avec k>2) d'étages supérieur. Ainsi, plus généralement, un dispositif quantique tel que mis en œuvre suivant l'invention peut comprendre un nombre d'étages de régions semi-conductrices superposées supérieur à deux.

En variante de l'un ou l'autre des exemples de réalisation décrits précédemment et dans lesquels on met en œuvre des interactions horizontales entre boite quantique BQ1, (respectivement BQ2) et ilot de détection ID1, (respectivement ID2), on peut prévoir un dispositif avec des interactions à la fois horizontales mais également verticales entre différents niveaux de régions semi-conductrices. Dans ce cas, on peut prévoir en particulier les zones de séparation ZS1, ZS2 illustrées sur la figure 1 avec des hauteurs H1, H2 prévues suffisamment faibles et à base d'un matériau diélectrique de constante diélectrique suffisamment élevée pour permettre un couplage électrostatique entre la première région semi-conductrice inférieure 102L et la première région semi-conductrice supérieure 104L ainsi qu'entre la deuxième région semi-conductrice supérieure 102R et la seconde région semi-conductrice supérieure 104R. Par exemple, pour permettre d'obtenir un couplage électrostatique entre une région semi-conductrice 104L, 104R supérieure et une région semi-conductrice inférieure 102L, 102R, en dessous, les zones de séparation ZS1, ZS2 peuvent être formées à base de matériau high-k (autrement dit à constant diélectrique k élevée), par exemple du HfO₂, avec une hauteur H1, H2 comprise par exemple entre 10 nm et 30 nm, avantageusement entre 10 nm et 20nm.

La capacité, qui est une valeur mesurable, entre 104L et 102L est supérieure à la capacité mesurée entre 104L et 104R.

Un dispositif quantique tel que décrit précédemment peut s'adapter à différents types de circuits de lecture. Par exemple il s'adapte à un circuit de lecture en transport où l'on lit l'état quantique d'une boite quantique par mesure du courant dans l'ilot de détection associé. Il s'adapte également à un circuit de lecture fonctionnant par réflectométrie où l'on émet un signal RF en direction de l'ilot de détection puis l'on détecte un signal RF réfléchi pour en déduire l'état de charge d'une boite quantique associée à cet ilot de détection.

Selon une autre possibilité de mise en œuvre du dispositif, il est prévu un couplage uniquement vertical entre régions semi-conductrices de différents niveaux. Cette possibilité n'est pas revendiquée, mais elle est présentée afin de faciliter la compréhension de l'invention. Ainsi un couplage capacitif est mis en œuvre entre une première région semi-conductrice de niveau inférieur ou supérieur formant une boite quantique et une autre région semi-conductrice de niveau différent et formant un ilot de détection, tandis qu'un tel couplage est empêché entre régions semi-conductrices de même niveau ou situées dans un même plan. Dans ce cas, par exemple, les zones de séparation ZS1, ZS2 sont prévues en termes de dimensions H1, H2 et de matériau diélectrique à base duquel elles sont formées de sorte à permettre un couplage électrostatique entre la première région semi-conductrice inférieure 102L et la première région semi-conductrice supérieure 104L, et de sorte à permettre un couplage électrostatique entre la deuxième région semi-conductrice inférieure 102R et la deuxième région semi-conductrice supérieure 102L. La région diélectrique RD peut alors être prévue en termes de dimensions D1, D2 et de matériau diélectrique composant cette région diélectrique, de sorte à empêcher un couplage électrostatique entre la première région semi-conductrice inférieure 102L et la deuxième région semi-conductrice inférieure 102R et également à empêcher un couplage électrostatique entre la première région semi-conductrice supérieure 104L et la deuxième région semi-conductrice supérieure 104R.

Un dispositif quantique tel que prévu selon l'un ou les modes précédemment décrits peut être mis en œuvre à l'aide d'un procédé de fabrication microélectronique en couches minces.

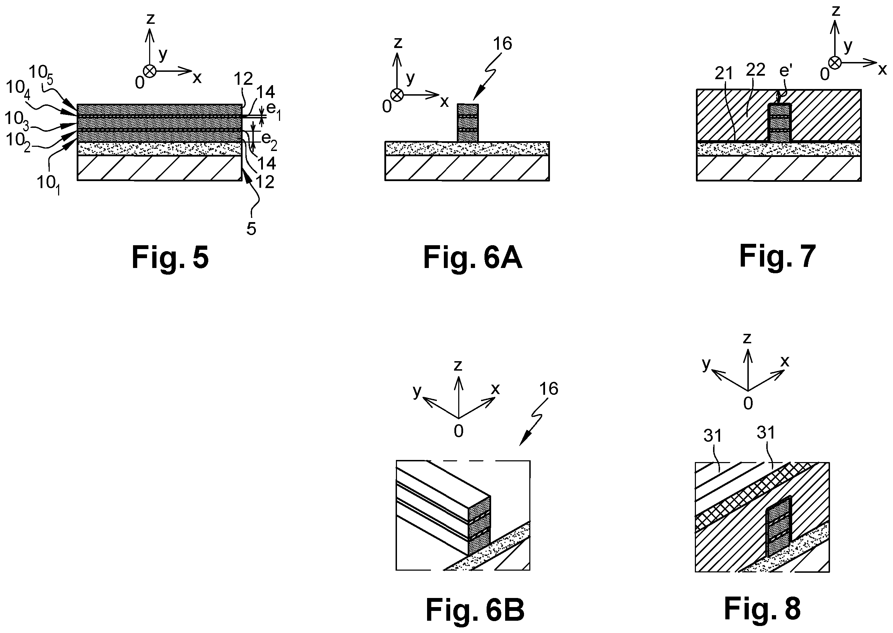

On se réfère tout d'abord à la figure 5 qui donne un exemple de structure de départ possible pour la réalisation d'un dispositif quantique suivant l'invention et qui comporte ici un substrat 5 qui peut être de type semi-conducteur sur isolant, par exemple SOI, ou de type massif et par exemple en silicium.

Un empilement de couches formé d'une alternance de couches 10₁, 10₃, 10₅ en un premier matériau 12 et de couches 10₂, 10₄, en un deuxième matériau 14 est réalisé sur le substrat 5. Les matériaux 12, 14 sont typiquement des matériaux semi-conducteurs différents l'un de l'autre, le premier matériau 12 étant apte à être gravé de manière sélective vis-à-vis du second matériau 14. L'exemple de réalisation particulier illustré sur la figure 5 prévoit un nombre impair de couches, en particulier cinq couches, mais le procédé peut être effectué avec un nombre de couches différent et en particulier supérieur.

Les couches 10₁, 10₃, 10₅ à base du premier matériau 12 peuvent être réalisées avantageusement avec une épaisseur supérieure à celle des couches 10₂, 10₄, à base du deuxième matériau 14, et qui peut être par exemple plus de deux fois supérieure à celle des couches 10₂, 10₄. Les couches 10₁, 10₃, 10₅ à base du premier matériau 12 peuvent avoir une épaisseur e₁ comprise par exemple, entre 10nm et 50nm, tandis que les couches 10₂, 10₄, ont une épaisseur e₂ comprise par exemple entre 5nm et 20nm.

Par exemple, le premier matériau 12 est en silicium tandis que le deuxième matériau 14 est en Si₁₋ₓGeₓ, avec x > 0, x étant par exemple de l'ordre de 30%. Les couches 10₁, 10₃, 10₅, 10₂, 10₄, peuvent être réalisées par épitaxies successives.

Lorsque la première couche 10₁ est en SiGe, on peut éventuellement former cette couche à partir d'une couche superficielle de silicium d'un substrat SOI par une méthode d'enrichissement en Germanium connue de l'Homme du métier et qui consiste à réaliser une épitaxie de silicium puis effectuer une oxydation afin de faire diffuser le germanium. Une gravure est ensuite réalisée de manière à retirer l'oxyde formé.

Ensuite (figures 6A et 6B), on définit par gravure de l'empilement de couches 10₁, 10₂, 10₃, 10₄, 10₅, une structure 16 de zone active, ici sous forme d'un bloc, typiquement de forme oblongue, par exemple parallélépipédique, et qui s'étend principalement dans une première direction (direction orthogonale au plan de la figure 1 et parallèle à l'axe y du repère orthogonal [0 ;x ;y ;°z]). Cela peut être réalisé par photolithographie et gravure de l'empilement. Une gravure sèche utilisant une chimie fluorocarbonnée à travers un masque de lithographie (non représenté) peut être pour cela effectuée.

On forme ensuite des motifs 25 de grille en matériau 22 de grille de part et d'autre de la structure 16.

Pour cela, on dépose tout d'abord au moins une couche 21 d'au moins diélectrique de grille, par exemple d'oxyde de silicium (SiO₂) ou formée d'un empilement d'oxyde de silicium et d'un matériau high-k tel que par exemple du HfO₂. Ce dépôt est suivi de celui d'au moins une couche de matériau 22 de grille, conducteur, tel que du polysilicium dopé (figure 7).

De préférence, après dépôt et une éventuelle planarisation par CMP on laisse une épaisseur e' non-nulle et par exemple de l'ordre de 50 nm de matériau conducteur 22 dépasser au-dessus de la structure 16 de zone active.

Des masques durs 31, typiquement diélectriques et par exemple formés d'un empilement de SiN et de SiO₂ sont ensuite réalisés (figure 8).

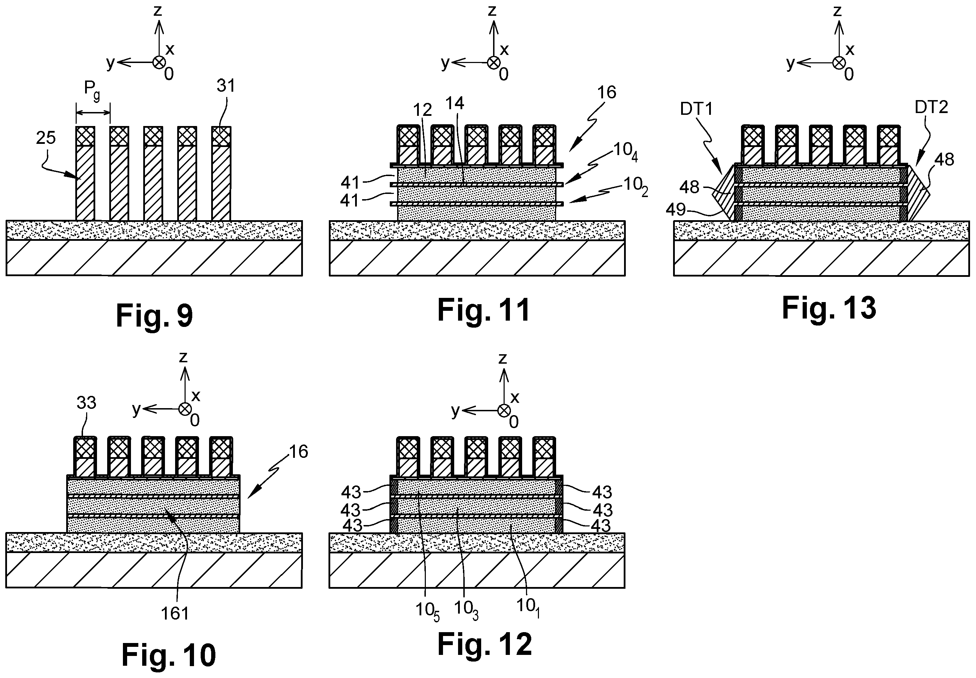

On effectue ensuite (figure 9 donnant une vue en coupe selon premier plan de coupe parallèle au repère [0 ;y ;°z]) une lithographie et une gravure de l'empilement de grille pour former un réseau de motifs 25 de grilles parallèles. Les motifs 25 de grille peuvent être répartis selon un pas Pg faible, par exemple de l'ordre de 100 nm, voire plus faible, par exemple de 40 nm, pour former un réseau dense de motifs 25.

Après la formation des motifs 25 de grille, on peut avantageusement former des réservoirs de dopants DT1, DT2 (figures 10 à 13).

Selon une méthode, on dépose tout d'abord de manière conforme une fine couche isolante d'espaceur 33 sur les motifs 25 de grille (figure 10 donnant une vue en coupe selon deuxième plan de coupe parallèle au repère [0 ;y ;°z] et distinct du premier plan de coupe de la figure 9), par exemple en nitrure de silicium et d'épaisseur qui peut être comprise par exemple entre 5 nm et 10 nm. La fine couche isolante d'espaceur 33 est agencée sur et entre les motifs 25 de grille, par exemple par une technique de type ALD (pour « Atomic Layer Deposition » ou « dépôt de couche atomique ») afin de remplir les espaces inter motifs-grilles sans création de défaut de remplissage.

On effectue ensuite une lithographie de sorte à retirer des portions de la fine couche isolante d'espaceur 33 et prolonger cette gravure dans des parties de la structure 16 de zone active situées autour d'une autre partie 161 à l'aplomb de l'ensemble des motifs 25 de grilles (figure 10 donnant une vue en coupe selon deuxième plan de coupe parallèle au repère [0 ;y ;°z] et différent du premier plan de coupe).

Pour former les réservoirs de dopants en contact avec les couches 10₂, 10₄ semi-conductrices dans lesquelles on prévoit de former les boites quantique et ilots de détection sans mettre en contact ces réservoirs avec les autres couches 10₁, 10₃, 10₅, de la structure, on peut avantageusement réaliser une gravure sélective partielle du premier matériau 12 vis-à-vis du deuxième matériau 14 afin de créer des renfoncements 41 (figure 11) au niveau de flancs de la structure 16. Par exemple lorsque le premier matériau 12 est en SiGe, cette gravure est effectuée par exemple réalisée par gravure chimique humide, ou à l'aide de HCl ou d'un mélange HF:H2O2:CH3COOH. Un retrait par exemple d'au moins 5nm peut être prévu pour réaliser ces renfoncements 41. Les renfoncements 41 sont ensuite comblés par des bouchons isolants 43 encore appelés « espaceurs internes » (figure 12). Cela peut être réalisé par exemple au moyen d'un dépôt conforme de matériau diélectrique, par exemple de SiN ou SiO₂. Ce dépôt est typiquement suivi d'une gravure sèche ou d'une combinaison de gravure sèche et humide du diélectrique déposé, de manière à former des bouchons isolants 43 bloquant l'accès aux couches 10₁, 10₃, 10₅ à base du premier matériau 12.

Une fois les bouchons 43 réalisés, on peut réaliser une épitaxie sélective de matériau semi-conducteur 48 à partir des extrémités dévoilées des couches 10₂, 10₄, à base du second matériau 14. L'épitaxie peut prévoir un dopage *in situ.* Par exemple des réservoirs de dopants DT1, DT2 en Si:P ou en SiGe:B peuvent être formés par épitaxie à partir d'extrémités de couches de silicium. L'épitaxie formée peut suivre ou non des orientations cristallines préférentielles, et les fronts d'épitaxie issus des différentes couches de Si peuvent éventuellement se rejoindre comme dans l'exemple de réalisation représenté sur la figure 13 pour former des blocs ou amas 49 semi-conducteurs.

On peut ensuite former des grilles superposées.

Pour cela, une méthode consiste tour d'abord à réaliser une encapsulation 52 isolante autour des motifs de grille. L'encapsulation isolante 52 peut être réalisée par exemple par dépôt d'un matériau de type PMD (pour « Pre Metal Dielectric ») tel que par exemple du SiO₂ sur l'ensemble de la structure suivi d'une étape de planarisation CMP. Cette étape est effectuée de préférence de manière à ce que le front de polissage s'arrête au sommet de la structure 16 de zone active. Cela permet de dévoiler le matériau 22 des motifs de grilles, typiquement un matériau de grille conducteur tel que du polysilicium.

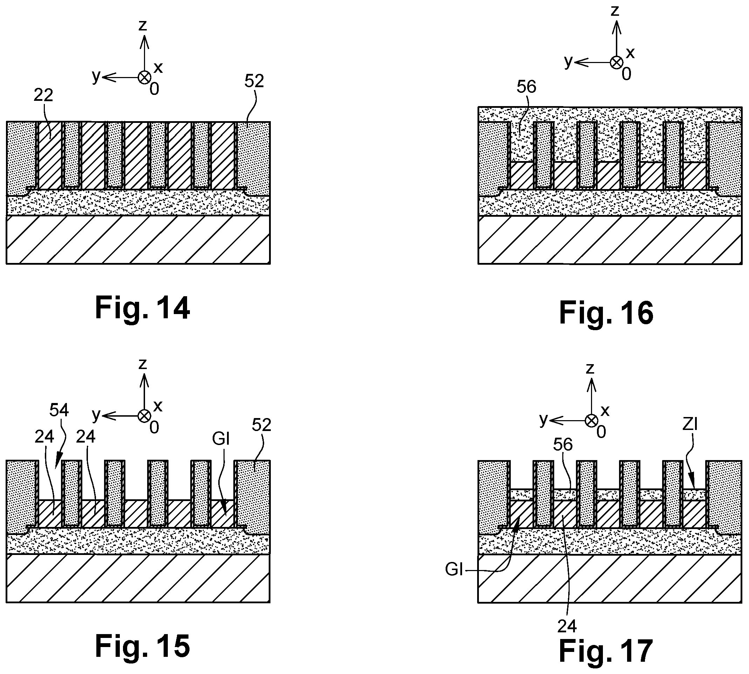

On réalise ensuite (figure 15) une gravure partielle du matériau 22 des motifs de grilles. Le retrait partiel du matériau 22 de grille est réalisé de sorte à conserver un bloc 24 inférieur de matériau de grille et réaliser des cavités 54 entourées par l'encapsulation 52 et disposées au-dessus de ce bloc inférieur 24 de matériau de grille. Une gravure sèche ou bien une gravure chimique, en particulier une gravure humide à l'aide de TMAH (« Tetramethylammonium hydroxide ») est en particulier mise en œuvre lorsque le matériau 22 est du polySi.

La gravure est réalisée de sorte à contrôler la hauteur du bloc 24 inférieur de matériau de grille par rapport à celle des couches semi-conductrices de la structure 16 de zone active. On met en œuvre un retrait partiel de sorte à ce que ce bloc 24 destiné à former une grille inférieure GI ne soit en regard que d'une seule couche 10₂ à base du deuxième matériau 14, en particulier que de la couche semi-conductrice de niveau inférieure destinée à accueillir des boites quantiques ou qubits.

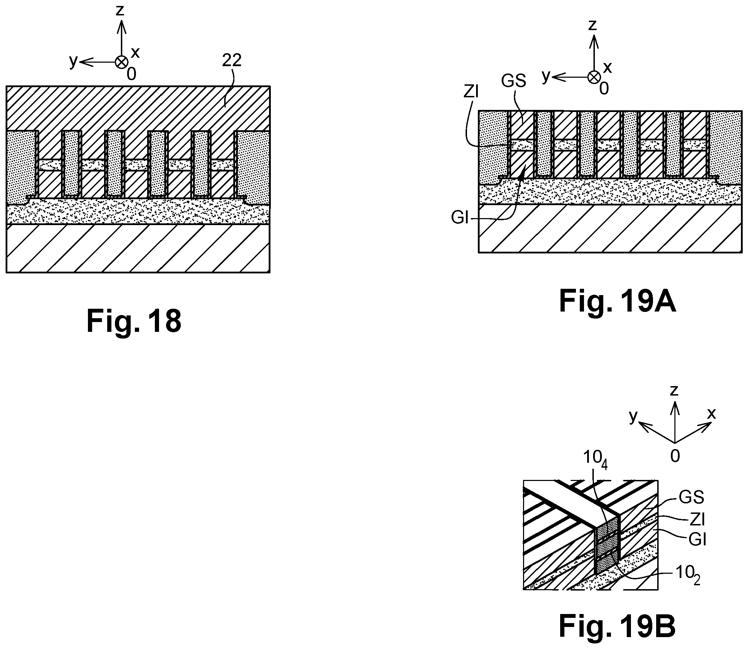

On remplit ensuite (figure 16) ces cavités 54 d'au moins une couche de matériau isolant 56, par exemple du SiO₂. Ce dépôt est éventuellement suivi d'une planarisation et d'une gravure pour retirer partiellement le matériau isolant 56 déposé (figure 17). Le matériau isolant 56 sert à former une zone d'isolation ZI permettant d'isoler entre eux les étages de grilles superposées. Une nouvelle couche de matériau conducteur, avantageusement à base du même matériau conducteur 22 que la grille inférieure GI, par exemple du polysilicium, est ensuite déposée (figure 18) de manière à combler les cavités 54. On effectue ensuite typiquement une planarisation par CMP (figures 19A, 19B) pour former ainsi une grille supérieure GS.

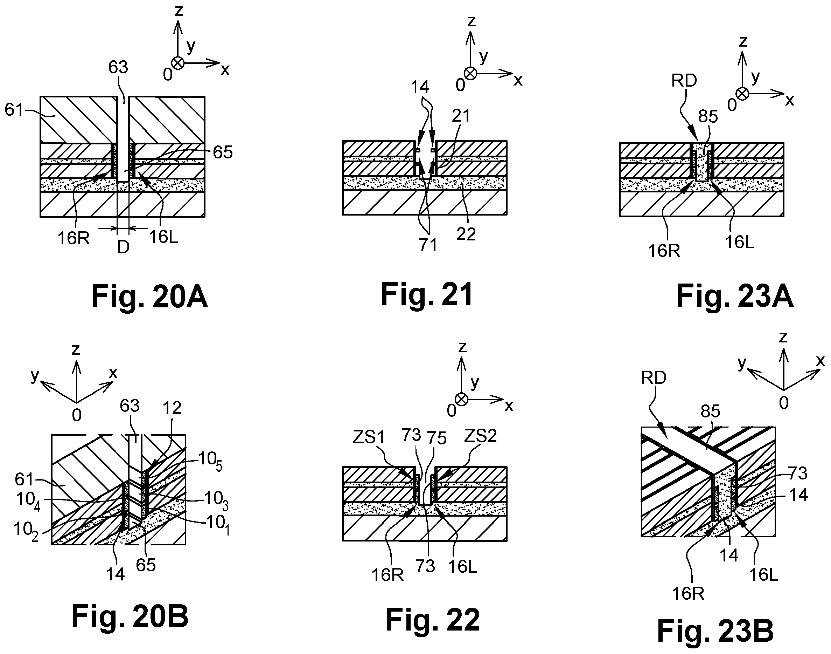

On réalise ensuite (figures 20A, 20B) une tranchée 65 de séparation afin de diviser la structure 16 de zone active en deux portions 16R, 16L distinctes. La tranchée 65 est réalisée typiquement jusqu'à atteindre le substrat 5 à travers l'ouverture 63 d'un masquage 61. La tranchée 65 s'étend principalement dans une direction parallèle à l'axe y donné sur les figures 20A et 20B correspondant également à la direction principale dans laquelle la première portion 16A et la deuxième portion 16B s'étendent.

Le masquage 61 est par exemple formé à base d'un empilement de résine lithograhique comprenant typiquement une résine photo-sensible formée sur une couche anti-refléchissante elle-même formée sur une couche dite « planarisante », typiquement organique et par exemple de type SOC (pour « Spin-On-Carbon »). La gravure de la tranchée est typiquement anisotrope, par exemple effectuée à l'aide un plasma fluorocarbonné.

Selon un exemple particulier de réalisation, la largeur D (dimension mesurée parallèlement à l'axe x sur la figure 20A) de la tranchée 65 correspondant à la distance entre les portions 16R, 16L a une dimension comprise entre 30nm et 60 nm, par exemple de l'ordre de 50nm. Cette tranchée 65 conduit à l'obtention de deux portions 16R, 16L qui se font face, chacune formée d'une même alternance de couches en un premier matériau et en un deuxième matériau, par exemple de SiGe et de Si.

Dans l'exemple de réalisation particulier où, plutôt qu'à base d'un matériau isolant, on utilise un premier matériau 12 semi-conducteur pour les couches 10₁, 10₃, 10₅ de l'empilement à base duquel les portions 16R, 16L sont chacune formées, on peut prévoir de remplacer ce matériau 12 semi-conducteur par un matériau diélectrique afin de former des zones de séparation entre les différents niveaux de couches 10₂, 10₄ à base du deuxième matériau 14.

Ainsi, dans ce cas, on effectue tout d'abord (figure 21) un retrait des couches 10₁, 10₃, 10₅ à base du premier matériau 12 par gravure sélective vis-à-vis du deuxième matériau 14. Dans le cas où le premier matériau 12 est en SiGe et le deuxième matériau 14 en silicium, ce retrait sélectif du SiGe afin d'effectuer une libération du silicium peut être réalisée par gravure isotrope et sélective des couches de SiGe par exemple par voir chimique humide et à base de HCl ou de HF:H2O2:CH3COOH.

On libère ainsi des espaces 71 entre régions à base du deuxième matériau 14. Les réservoirs de dopants (non visibles sur la figure 21) peuvent alors participer au maintien des régions semi-conductrices à base du deuxième matériau 14.

On vient ensuite combler par un matériau diélectrique 73 de sorte à former des zones « de séparation » isolante ZS1, ZS2.

Le choix du matériau diélectrique des zones isolantes ZS1, ZS2 effectué en particulier en termes de permittivité ou de constante diélectrique de ce matériau dépend de si l'on souhaite ou non favoriser un couplage dans la direction verticale (direction parallèle à l'axe z) entre étages semi-conducteurs successifs de matériau 14 dans les portions 16A, 16B.

On réalise typiquement les zones isolantes ZS1, ZS2 par un dépôt conforme de matériau diélectrique 73 puis une gravure anisotrope ou une combinaison de gravure(s) anisotrope(s)/isotrope(s) de ce matériau diélectrique 73 de sorte à ne conserver ce matériau diélectrique 73 que dans des espaces situés à l'aplomb des régions restantes des couches semiconducteurs 10₂, 10₄ à base du deuxième matériau 14 (figure 22). Un volume vide non rempli restant formant une tranchée réduite 75 est ainsi réalisé entre les deux portions 16R, 16L de structure 16 de zone active.

On forme ensuite (figures 23A et 23B) la région diélectrique RD de séparation entre la première portion 16R dotée d'un premier ensemble de régions semi-conductrices à base du deuxième matériau 14 entre la deuxième portion 16L dotée d'un premier ensemble de régions semi-conductrices à base du deuxième matériau 14.

On réalise pour cela typiquement un dépôt conforme de matériau diélectrique 85 puis une planarisation CMP de ce matériau diélectrique 85 de manière à remplir le volume vide restant formant une tranchée réduite 75 séparant les deux portions 16R, 16L. Deux ensemble de régions semiconductrices se faisant face-à-face sont alors séparés par ce matériau diélectrique 85. Là encore, le diélectrique et sa permittivité sont choisis de manière à favoriser ou non le couplage dans la direction horizontale (direction parallèle à l'axe x) entre les deux réseaux de régions semiconductrices se faisant face-à-face.

Dans l'exemple de procédé de réalisation qui vient d'être donné, pour la mise en œuvre des grilles superposées GI, GS, on prévoit des grilles inférieures GI formées à base d'un même matériau 22 que les grilles supérieures GS. Il est en variante toutefois possible de prévoir des matériaux différents entre les grilles inférieures GI d'une part et les grilles supérieures GS d'autre part.

De même, dans l'exemple de réalisation qui vient d'être donné, les grilles formées contre la portion 16R de zone active dédiée par exemple à l'accueil des boites quantiques sont à base d'un même matériau que celles situées contre la portion 16L de zone active qui lui fait face et qui est dédiée par exemple à l'accueil des ilots de détection.

Il est en variante toutefois possible de prévoir des matériaux différents entre d'une part les grilles situées contre la portion 16R et d'autre part les grilles situées contre la portion 16L. Une telle variante peut être réalisée pour obtenir des travaux de sortie et par conséquent des régimes de fonctionnement différents entre par exemple des grilles contrôlant les boites quantiques et des contrôlant grilles contrôlant les ilots de détection. Pour réaliser une telle variante, on peut prévoir d'ajouter une ou plusieurs étapes de lithographie et une ou plusieurs étapes de dépôt supplémentaires.

En variante de l'exemple de procédé de réalisation qui vient d'être donné la mise en œuvre des grilles superposées GI, GS, qui décrit une approche de type communément appelée « gate-last » (grille en dernier) où l'on effectue un remplacement au moins partiel de motifs par un empilement avec des grilles séparées d'une zone d'isolation, on peut prévoir de réaliser directement cet empilement.

Ainsi, selon une variante de réalisation des grilles, une approche de type appelée « gate-first » (grille en premier) peut être prévue. Dans ce cas, directement après l'étape de formation de la structure 16 de zone active décrite précédemment en lien avec les figures 6A-6B, on peut prévoir la réalisation d'un empilement de couches pour former la grille inférieure, la zone d'isolation, puis la grille supérieure. Les épaisseurs des couches conductrices ou semi-conductrices de matériau(x) de grille et de la couche isolante intercalée sont alors ajustées de préférence en fonction de celles des couches de premier matériau 12 et de deuxième matériau 14 de la structure 16 afin que chaque couche de matériau de grille soit disposée en vis-à-vis et dans un même plan parallèle au plan principal du substrat qu'une couche à base du deuxième matériau semi-conducteur 14 et dans lequel des boites quantiques ou ilots de détection sont prévus.

Dans l'un ou l'autre des exemples de réalisation qui viennent d'être décrits, la prise de contact sur des niveaux de grilles différents ainsi que sur des niveaux de couches semi-conductrices différentes, peut être réalisée par exemple en prévoyant, aux extrémités des structures de grilles ou des portions de zone active, une forme en escalier.

Dans un dispositif quantique tel que décrit précédemment, où l'on favorise des interactions horizontales (autrement dit dans des directions parallèles au plan principal du substrat) entre une d'une part une boite quantique BQ1 (respectivement BQ2) et d'autre part un ilot de détection ID1 (respectivement ID2) situé dans un même plan horizontal que cette boite quantique BQ1 (resp. BQ2), on peut vouloir en outre éviter un couplage dit « diagonal » dans une direction diagonale DIAG1 (resp. DIAG2) entre une boite quantique BQ1 (resp. BQ2) et un ilot de détection ID2 (respectivement ID1) situé dans un autre plan que cette boite quantique BQ1 (resp. BQ2).

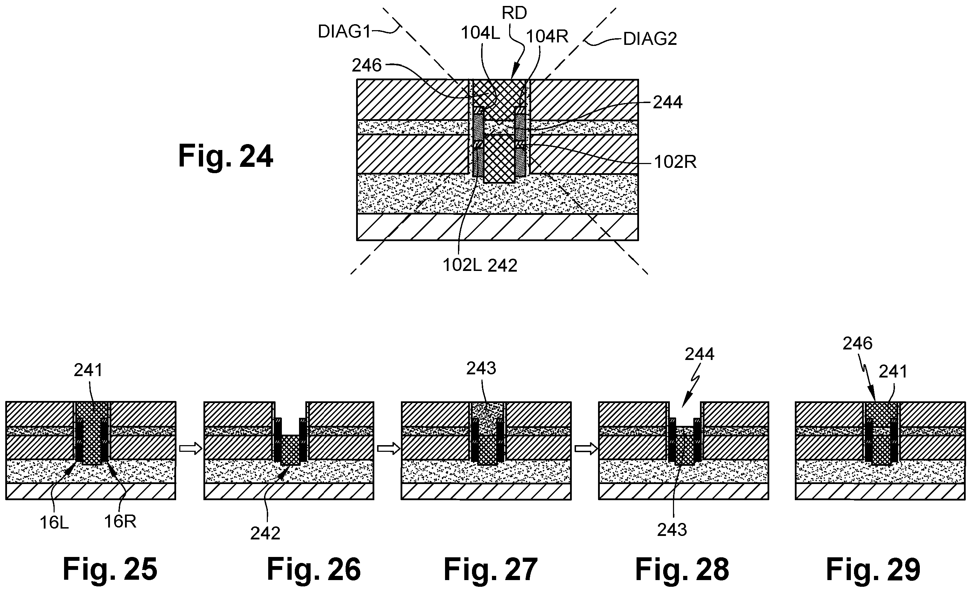

Ainsi dans un exemple de réalisation illustré sur la figure 24, on prévoit pour cela une région diélectrique RD entre l'ensemble de régions semi-conductrices 102R, 104R et l'ensemble de régions semi-conductrices 102L, 104L avec ici une composition hétérogène. Une portion centrale 244 située entre une première région semi-conductrice inférieure 102R et une deuxième région semi-conductrice supérieure 104L et entre la première région semi-conductrice supérieure 104R et la deuxième région semi-conductrice inférieure 102L est à base d'un matériau diélectrique ayant une composition et une première permittivité diélectrique relative. Une autre portion 242, de la région diélectrique RD située entre la première région semi-conductrice inférieure 102R et la deuxième région semi-conductrice inférieure 102L est prévue à base d'un autre matériau diélectrique ayant une composition et une permittivité diélectrique relative différente et plus élevée que celle du matériau de la portion centrale 244. Une portion 246, de la région diélectrique RD située cette fois entre la première région semi-conductrice supérieure 104R et la deuxième région semi-conductrice supérieure 102L est également prévue à base d'un matériau diélectrique ayant une composition et une permittivité diélectrique relative plus élevée que celle du matériau de la portion centrale 244.

Un exemple de procédé pour réaliser un tel type de dispositif est illustré sur les figures 25 à 28.

On peut partir d'une structure telle que décrite en liaison avec la figure 22. Puis (figure 25) on dépose un matériau diélectrique 241, de manière à remplir l'espace séparant les deux portions 16R, 16L. Ce matériau diélectrique 241 peut être ensuite planarisé, par exemple par CMP (« Chemical mechanical planarization », i.e. « polissage mécanochimique »).

Le matériau diélectrique 241, par exemple tel que du SiN ou HfO₂, est ensuite retiré partiellement (figure 26) typiquement par gravure humide à l'aide de H₃PO₄ dans le cas SiN ou plasma CH₂F₂, SF₆ dans le cas SiN, CF₄/Ar dans le cas HfO₂ afin de former la portion 242 inférieure de la région d'isolation.

On dépose ensuite un autre matériau diélectrique 243 typiquement de permittivité diélectrique plus faible que la permittivité diélectrique du matériau diélectrique 241 (figure 27). L'autre matériau diélectrique 243 peut être par exemple du SiO₂ et former la portion centrale 244 de la région diélectrique RD.

Une éventuelle planarisation par CMP de cet autre matériau 243, est alors réalisée.

Dans l'exemple de réalisation particulier illustré sur la figure 28, on effectue ensuite un retrait partiel typiquement par gravure humide à l'aide de HF ou plasma CF₄ de cet autre matériau 243 afin de former la portion centrale 244 de la région diélectrique RD.

On peut ensuite déposer à nouveau le matériau diélectrique 241 afin de former une portion supérieure 246 de la région diélectrique RD (figure 29) qui, dans cet exemple, a une composition identique à celle de la portion inférieure 242. Ce matériau diélectrique 241 peut être ensuite planarisé, par exemple par CMP.

En variante, la portion supérieure 246 peut être formée à base d'un troisième matériau diélectrique différent de celui des portions 242, 244 mais avec une permittivité diélectrique plus importante que la permittivité diélectrique du matériau diélectrique 243 de la portion centrale 244.

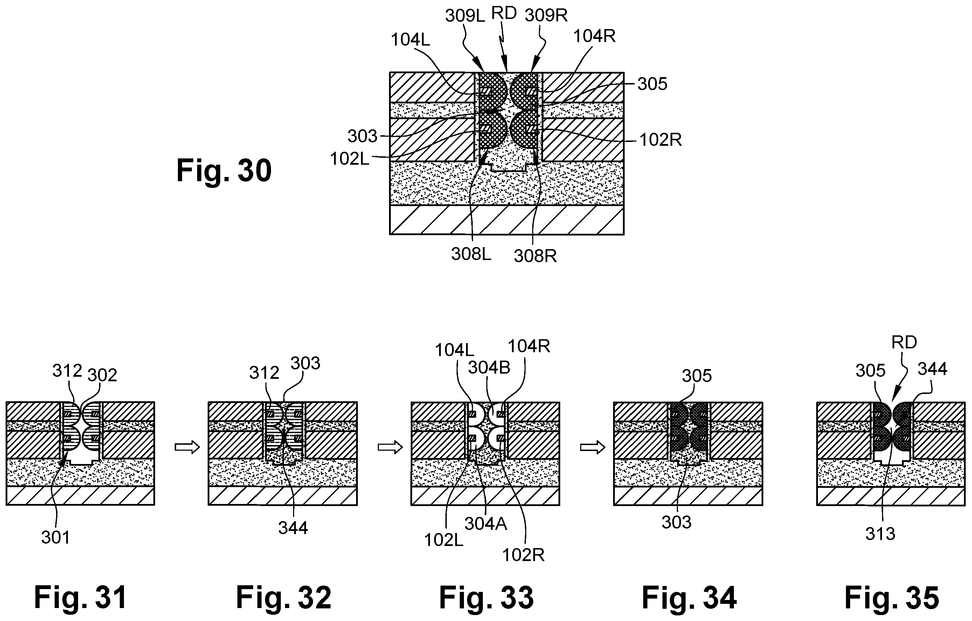

Un autre exemple de réalisation d'une région diélectrique RD hétérogène en termes de composition de matériau diélectrique est donné sur la figure 30.

La région diélectrique RD est ici formée d'un matériau diélectrique 305 ayant un constante diélectrique k1 enrobant chacune des premières et deuxièmes régions semi-conductrices inférieure et supérieure 102R, 102L, 104R, 104L, de sorte à former des bosses isolantes inférieures 308R, 308L contre les premières et deuxièmes régions semi-conductrices inférieure 102R, 102L et des bosses isolantes supérieures 309R, 309L contre les premières et deuxièmes régions semi-conductrices supérieures 102R, 104R.

Un espace isolant formé entre les bosses isolantes 308R, 308L 309R, 309L est ici comblé par un matériau diélectrique 303 ayant un deuxième constante diélectrique k2 plus faible que la constante diélectrique k1 du matériau diélectrique 305. Une portion 344 centrale de matériau diélectrique 303 est ainsi prévue pour empêcher le couplage « diagonal » entre les régions semi-conductrices 102L et 104R, et entre les régions semi-conductrices 102R, 104L.

Un exemple de procédé pour réaliser un tel type de dispositif est illustré sur les figures 31 à 34.

On peut partir d'une structure telle que décrite en liaison avec la figure 21 obtenue après gravure sélective du premier matériau 12 afin de libérer les régions 102R, 102L, 104R, 104L à base du premier matériau 14.

On forme tout d'abord (figure 31) une enveloppe semi-conductrice 301 par épitaxie sur les régions 102R, 102L, 104R, 104L à base d'un matériau semi-conducteur sacrificiel 312. On choisit de faire croitre, de préférence de manière isotrope, un matériau semi-conducteur 312 qui peut être gravé sélectivement vis-à-vis du deuxième matériau 14. Dans l'exemple particulier illustré sur la figure 31, cette enveloppe semi-conductrice sacrificielle 301 peut être identique au premier matériau 12, par exemple du SiGe lorsque le matériau 14 des régions 102R, 102L, 104R, 104L est en silicium. La croissance est réalisée de préférence de sorte à former des bosses semi-conductrices et à préserver un espace 302 entre des bosses semi-conductrices formée sur la première portion 16A de la structure de zone active et la deuxième portion 16B située en face et séparée de la première portion 16A.

On comble ensuite cet espace 302 par un matériau diélectrique donné 303 ayant de constante diélectrique k2 donnée, par exemple du SiO₂ (figure 32). Cela peut être réalisé par dépôt puis planarisation CMP.

On effectue ensuite un retrait sélectif de l'enveloppe semi-conductrice 301 à base du matériau sacrificiel 312 (figure 33). Une gravure sélective du SiGe par rapport au silicium peut être en particulier mise en œuvre. Une telle gravure conduit à la formation de galeries 304A, 304B autour des régions semi-conductrices 102R, 102L, 104R, 104L à base du premier matériau 14.

On comble ensuite les galeries 304A, 304B par le biais d'un matériau diélectrique 305 de constante diélectrique k1, par exemple du SiN ou HfO₂ ou Al₂O₃. Un procédé de dépôt ALD (ALD pour « Atomic Layer Deposition ») peut être en particulier mis en œuvre afin d'éviter tout défaut de remplissage (figure 34).

Selon une variante de réalisation, on peut prévoir à la place du matériau diélectrique 303 de constante diélectrique k2 de réaliser une région diélectrique RD séparant les deux portions 16A, 16B de la structure de zone active, avec un espace vide ou rempli d'air 313 dans une portion centrale 344 de la région diélectrique RD et située entre les bosses isolantes à base du matériau diélectrique 305 de constante diélectrique k1. Cela peut permettre de limiter davantage les possibilités de couplage diagonal entre régions semi-conductrices 102L, 104R et 104L, 102R.

Pour mettre en œuvre une telle variante, on peut partir d'une structure telle qu'obtenue précédemment et décrite en liaison avec la figure 34, puis réaliser un retrait sélectif du matériau diélectrique 303 de constante diélectrique k2 vis-à-vis du matériau diélectrique 305 de constante diélectrique k1. Un tel retrait sélectif est par exemple effectué à l'aide de H₃PO₄ lorsque le matériau diélectrique 303 et le matériau diélectrique 305 sont respectivement du SiN et du HfO₂.

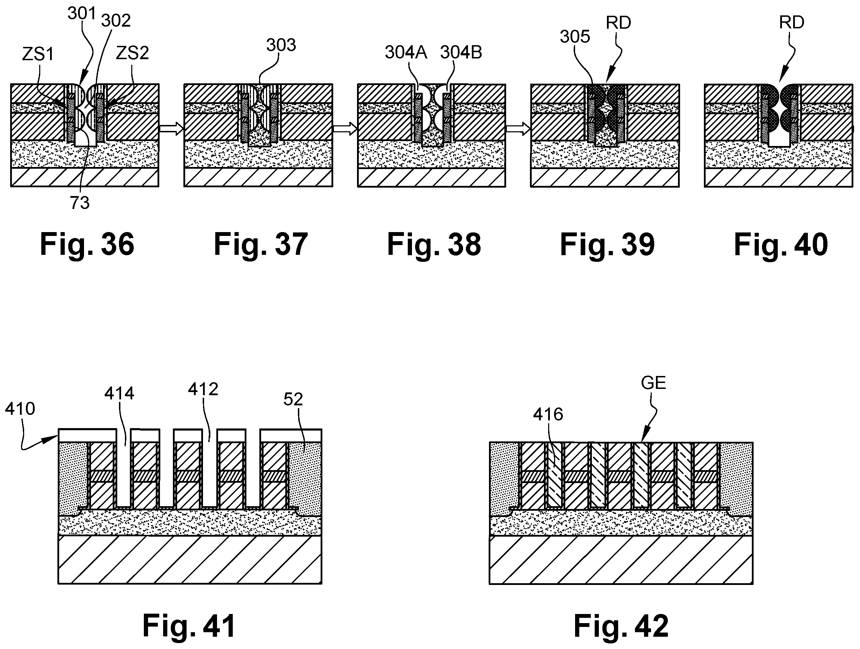

Un autre exemple de procédé de réalisation de la région diélectrique RD entre les deux portions 16A, 16B de zone active est illustré sur les figures 36 à 41.

On peut partir cette fois d'une structure du type de celle décrite en liaison avec la figure 22 pour obtenir les zones de séparation ZS1, ZS2 en matériau isolant 73.

On forme alors tout d'abord (figure 36) l'enveloppe semi-conductrice sacrificielle 301 par épitaxie sur les régions 102R, 102L, 104R, 104L semi-conductrices.

On dépose ensuite le matériau diélectrique 303 de constante diélectrique k2, par exemple du SiO₂ (figure 37).

On effectue ensuite le retrait sélectif de l'enveloppe semi-conductrice sacrificielle 301 à base du premier matériau 12 (figure 38) de manière à former les galeries 304A, 304B autour des régions semi-conductrices 102R, 102L, 104R, 104L à base du premier matériau 14.

On comble ensuite les galeries 304A, 304B à l'aide du matériau diélectrique 305 de constante diélectrique k1, par exemple du SiN ou HfO₂ ou Al₂O₃, avantageusement en procédé de dépôt de type ALD afin d'éviter un défaut de remplissage (figure 39) pour former la région diélectrique RI de composition hétérogène.

Comme pour l'exemple de réalisation décrit précédemment, on peut, là encore, de manière optionnelle, retirer ensuite sélectivement le matériau diélectrique 303 de constante diélectrique k2 (figure 40).

En variante de l'un ou l'autre des exemples de procédé qui viennent d'être décrits, on peut prévoir de réaliser des électrodes d'échange dans des espaces inter-grilles.

Pour cela, une méthode illustrée sur les figures 41 et 42 consiste à partir d'une structure telle qu'obtenue à l'issue de la réalisation des grilles et décrite par exemple précédemment en liaison avec les figures 19A-19B. On réalise ensuite un masquage 410, typiquement en résine photosensible, dans une zone située au-dessus de l'ensemble blocs de grilles et qui comporte des ouvertures 412 en regard d'espaces inter-grilles (figure 41). On grave ensuite de manière sélective le matériau d'encapsulation 52, par exemple du SiO2, situé dans les espaces inter-grilles sélectivement par rapport à la fine couche d'espaceur 33, par exemple en SiN, afin de former des trous 414. Un procédé de gravure sèche fluorocarbonnée peut être en particulier utilisé.

Après retrait du masquage 410, un dépôt de matériau conducteur 416, par exemple un empilement de type TiN/W est réalisé pour remplir les trous 414 ainsi définis (figure 42). Ce dépôt est typiquement suivi d'une étape de planarisation CMP. L'arrêt de la planarisation est effectué de préférence lorsque l'on atteint le sommet de la structure de zone active (non visible sur les figures 41 et 42). Dans cet exemple de réalisation on réalise une seule électrode d'échange GE par espace inter-grille.

Toutefois, il est en variante possible de former des grilles d'échange superposées et qui suivent un agencement semblable à celui des électrodes de grilles entre lesquelles ces grilles d'échange sont inter-callées. On peut ainsi former dans chaque espace inter-grille des paires de grilles d'échange superposées et séparées entre elle d'un isolant. Pour cela, on peut suivre un procédé semblable à celui utilisé pour réaliser les grilles et décrit précédemment en liaison avec les figures 15 à 19A-19B.

## Revendications

1. Dispositif électronique quantique doté d'un substrat (5), le substrat étant revêtu :
- d'un premier ensemble de régions semi-conductrices (102L, 104L) comprenant au moins une première région semi-conductrice inférieure (102L) et au moins une première région semi-conductrice supérieure (104L), superposée à, et séparée de, la première région semi-conductrice inférieure par le biais d'une première zone dite « de séparation » (ZS1), en matériau diélectrique,
- d'un deuxième ensemble de régions semi-conductrices (102R, 104R) comprenant au moins une deuxième région semi-conductrice inférieure (102R) et au moins une deuxième région semi-conductrice supérieure (104R), superposée à, et séparée de, la deuxième région semi-conductrice inférieure par le biais d'une deuxième zone dite « de séparation » (ZS2) en matériau diélectrique, lesdites première et deuxième régions semi-conductrices inférieures (102L, 102R) étant agencées dans un même premier plan (P1), tandis que lesdites première et deuxième régions semi-conductrices supérieures (104L, 104R) sont agencées dans un même deuxième plan (P2), les premier et deuxième plans (P1, P2) étant parallèles à un plan principal du substrat (5),
le premier ensemble de régions semi-conductrices (102L, 104L) étant disposé en vis-à-vis du deuxième ensemble de régions semi-conductrices (102R, 104R) de sorte que la première région semi-conductrice inférieure (102L) est disposée en regard de la deuxième région semi-conductrice inférieure (102R) et de sorte que la première région semi-conductrice supérieure (104L) est disposée en regard de la deuxième région semi-conductrice supérieure (104R),
- d'au moins une région diélectrique (RD) séparant le premier ensemble de régions semi-conductrices (102R, 104R) du deuxième ensemble de régions semi-conductrices (102R, 104R),
- d'un premier groupe de grilles (GI1, GS1) superposées comprenant au moins une première grille inférieure (GI1) et une première grille supérieure (GS1) superposée à, et séparée de la première grille inférieure par une première zone d'isolation (ZI1), la première grille inférieure (GI1) et la première grille supérieure (GS1) étant disposées contre, et en regard, respectivement de la première région semi-conductrice inférieure (102L) et de la première région semi-conductrice supérieure (104L) de sorte à exercer respectivement un contrôle électrostatique de la première région semi-conductrice inférieure et de la première région semi-conductrice supérieure,
- d'un deuxième groupe de grilles (GI2, GS2) superposées comprenant au moins une deuxième grille inférieure (GI2) séparée d'une deuxième grille supérieure (GS2) superposée à, et séparée de la deuxième grille inférieure par une deuxième zone d'isolation (ZI2), la deuxième grille inférieure (GI2) et la deuxième grille supérieure (GS2) étant disposées contre, et en regard, respectivement de la deuxième région semi-conductrice inférieure (102R) et de la deuxième région semi-conductrice supérieure (104R) de sorte à exercer respectivement un contrôle électrostatique de la deuxième région semi-conductrice inférieure (102R) et de la deuxième région semi-conductrice supérieure (104R), le premier groupe de grilles superposées et le deuxième groupe de grille superposées étant disposés de part et d'autre du premier ensemble de régions semi-conductrices et du deuxième ensemble de régions semi-conductrices,
ladite région diélectrique (RD) séparant le premier ensemble de régions semi-conductrices (102R, 104R) du deuxième ensemble de régions semi-conductrices (102R, 104R) étant prévue de sorte à permettre un couplage électrostatique entre la première région semi-conductrice inférieure (102L) et la deuxième région semi-conductrice inférieure (102R), et de sorte à permettre un couplage électrostatique entre la première région semi-conductrice supérieure (104L) et la deuxième région semi-conductrice supérieure (104R).

2. Dispositif électronique quantique selon la revendication 1, dans lequel la première région semi-conductrice inférieure (102L) et la première région semi-conductrice supérieure (104L) sont des régions respectivement d'un barreau semi-conducteur inférieur (102) et d'un barreau semi-conducteur supérieur (104), le barreau semi-conducteur inférieur et le barreau semi-conducteur supérieur s'étendant parallèlement à une première direction (y) parallèle au plan principal du substrat,
le dispositif étant doté d'un troisième groupe de grilles superposées (GI3, GS3) juxtaposé audit premier groupe de grilles (GI1, GS1) et où le troisième groupe de grilles (GI3, GS3) superposées comprend au moins une troisième grille inférieure (GI3) séparée d'une troisième grille supérieure (GS3) superposée à, et séparée de la troisième grille inférieure par une troisième zone d'isolation, la troisième grille inférieure (GI3) et la troisième grille supérieure (GS3) étant disposées contre, et en regard, respectivement d'une troisième région semi-conductrice inférieure (102L2) du barreau semi-conducteur inférieur (102) et d'une troisième région semi-conductrice supérieure (104L2) du barreau semi-conducteur supérieur (104) pour les contrôler électro-statiquement.

3. Dispositif électronique quantique selon la revendication 2, dans lequel ledit barreau semi-conducteur inférieur (102) et ledit barreau semi-conducteur supérieur (104), sont respectivement un premier barreau semi-conducteur inférieur et un premier barreau semi-conducteur supérieur, la deuxième région semi-conductrice inférieure (102R) et la deuxième région semi-conductrice supérieure (104R) étant des régions respectivement d'un deuxième barreau semi-conducteur inférieur et d'un deuxième barreau semi-conducteur supérieur, lesdits deuxièmes barreau semi-conducteur inférieur et supérieur s'étendant parallèlement respectivement auxdits premier barreau semi-conducteur inférieur (102) et supérieur (104), le dispositif étant doté d'un quatrième groupe (GI4, GS4) de grilles superposées juxtaposé audit deuxième groupe de grilles superposées pour le contrôle électrostatique d'une quatrième région semi-conductrice du deuxième barreau semi-conducteur inférieur (102) et d'une quatrième région semi-conductrice supérieure du deuxième barreau semi-conducteur supérieur (104), le premier barreau semi-conducteur inférieur (102) et le deuxième barreau semi-conducteur inférieur (102') étant situés dans le premier plan (P1), le premier barreau semi-conducteur supérieur et le deuxième barreau semi-conducteur supérieur étant situés dans le deuxième plan (P2), la troisième région semi-conductrice inférieure étant disposée en regard de la quatrième région inférieure, la troisième région semi-conductrice supérieure étant disposée en regard de la quatrième région semi-conductrice supérieure.

4. Dispositif selon la revendication 3, comprenant en outre, dans une direction parallèle à la première direction (y), entre ledit premier groupe de grilles (GI1, GS1) et ledit troisième groupe de grilles (GI3, GS3) :
- au moins une électrode d'échange (GE) ou
- des électrodes d'échanges superposées (GE11, GE12) et séparées l'une de l'autre par une couche de séparation isolante (CSI),
- une zone d'au moins un matériau isolant (53).

5. Dispositif selon l'une des revendications 1 à 4, dans lequel le dispositif comprenant en outre :
- un bloc semi-conducteur dopé, formant un premier réservoir de dopants (DT1), le bloc semi-conducteur dopé étant agencé à une première extrémité du premier barreau semi-conducteur supérieur, du premier barreau semi-conducteur inférieur, du deuxième barreau semi-conducteur supérieur, et du deuxième barreau semi-conducteur inférieur,
- un autre bloc semi-conducteur dopé, formant un deuxième réservoir de dopants (DT2), l'autre bloc semi-conducteur dopé étant agencé à une deuxième extrémité du premier barreau semi-conducteur supérieur, du premier barreau semi-conducteur inférieur, du deuxième barreau semi-conducteur supérieur, du deuxième barreau semi-conducteur inférieur, et qui est opposée à la première extrémité.

6. Dispositif selon l'une des revendications 1 à 5, dans lequel la région diélectrique (RD) entre le premier ensemble de régions semi-conductrices (102L, 104L) et le deuxième ensemble de régions semi-conductrices (102R, 104R) est prévue avec une composition diélectrique hétérogène de sorte que dans une portion centrale (244, 303) située entre la première région semi-conductrice inférieure et la deuxième région semi-conductrice supérieure et entre la première région semi-conductrice supérieure et la deuxième région semi-conductrice inférieure, la région diélectrique (RD) a une première composition et une première permittivité diélectrique relative, et que dans une autre portion (242, 246) située entre la première région semi-conductrice inférieure et la deuxième région semi-conductrice inférieure ou entre la première région semi-conductrice supérieure et la deuxième région semi-conductrice supérieure, la région diélectrique (RD) a une deuxième composition et une deuxième permittivité diélectrique relative plus élevée que la première permittivité diélectrique relative.

7. Dispositif selon l'une des revendications 1 à 6, lesdites zones de séparation (ZS1, ZS2) étant prévues de sorte à permettre un couplage électrostatique entre la première région semi-conductrice inférieure (102L) et la première région semi-conductrice supérieure (104L), et de sorte à permettre un couplage électrostatique entre la deuxième région semi-conductrice inférieure (102R) et la deuxième région semi-conductrice supérieure (102L).

8. Procédé de fabrication d'un dispositif quantique selon l'une des revendications 1 à 7, dans lequel la formation du premier ensemble de régions semi-conductrices (102L, 104L) et dudit deuxième ensemble (102R, 104R) de régions semi-conductrices comprend des étapes de :
- réalisation sur ledit substrat (10) d'une structure (16) formé d'une superposition de couches (10₁, 10₂, 10₃, 10₄, 10₅) composée d'une alternance de couches (10₁, 10₃, 10₅) à base d'un premier matériau (12) donné, et de couches (10₂, 10₄) à base d'un deuxième matériau, le deuxième matériau étant semi-conducteur, ledit premier matériau donné étant apte à être gravé sélectivement vis-à-vis dudit deuxième matériau donné,
- réalisation d'une tranchée (65) de séparation s'étendant principalement dans une direction parallèle à la première direction par gravure de ladite superposition de couches de sorte à de sorte à diviser ladite structure en une première portion (16A) et une deuxième portion (16B), la première portion (16A) et la deuxième portion (16B) s'étendant parallèlement à la première direction, les régions semi-conductrices dudit premier ensemble étant des régions semi-conductrices de la première portion et formées à base dudit deuxième matériau donné, les régions semi-conductrices dudit deuxième ensemble étant des régions semi-conductrices de la deuxième portion et formées à base dudit deuxième matériau donné.

9. Procédé de fabrication d'un dispositif quantique selon la revendication 8, comprenant en outre, après réalisation de ladite tranchée (65), la formation de ladite région diélectrique (RD) par dépôt d'un ou plusieurs matériau diélectriques (85) entre ladite première portion (16A) et ladite deuxième portion (16B) de ladite structure (16).

10. Procédé de fabrication d'un dispositif quantique selon la revendication 8 ou 9, comprenant en outre après réalisation de la tranchée de séparation et préalablement à la formation de ladite région diélectrique (RD), des étapes de :
- gravure au moins partielle dudit premier matériau (12) donné et sélective vis-à-vis du deuxième matériau (14) dans la première portion (16A) et ladite deuxième portion (16B) de sorte à libérer des espaces (71),
- remplissage desdits espaces (71) par un matériau diélectrique (73) de sorte à former la première zone « de séparation » (ZS1) et la deuxième zone « de séparation » (ZS2).

11. Procédé selon la revendication 10, comprenant en outre, après avoir rempli lesdits espaces (71) par un matériau diélectrique (73) donné, des étapes de :
- gravure anisotrope du matériau diélectrique de sorte à libérer un espace formant une tranchée réduite (75) entre lesdites portions (16A, 16B) de zone active,
- remplissage de la tranchée réduite (75) au moyen d'au moins un autre matériau diélectrique différent dudit matériau diélectrique donné.

12. Procédé selon l'une des revendications 8 à 11, comprenant en outre, après formation de ladite structure (16) et préalablement à la formation de ladite tranchée de séparation dans cette structure (16), des étapes de :
- formation de motifs de grille en matériau de grille de part et d'autre de la structure,
- formation d'une encapsulation (52) isolante autour des motifs de grille,
- retrait partiel du matériau de grille de sorte à conserver un bloc inférieur (GI) de matériau de grille et réaliser des cavités (54) au-dessus de ce bloc inférieur de matériau de grille et entourées par l'encapsulation (52),
- remplir les cavités d'au moins une couche isolante de sorte à former une zone d'isolation (ZI) sur le bloc inférieur de matériau de grille puis,
- remplir les cavités d'au moins une couche de matériau de grille, de sorte à former un bloc supérieur (GS) de matériau de grille sur la zone d'isolation (ZI).

13. Procédé de fabrication d'un dispositif quantique selon l'une des revendications 11 ou 12, comprenant en outre,
après formation de ladite structure (16) et préalablement à la formation de ladite tranchée (65) de séparation dans cette structure, une formation de réservoirs de dopants à des extrémités de ladite structure, la formation desdits réservoirs de dopants comprenant :
- réaliser une gravure sélective partielle du premier matériau (12) vis-à-vis du deuxième matériau (14) afin de créer des renfoncements (41) au niveau desdites extrémités de ladite structure (16),
- combler lesdits renfoncements (41) par un matériau isolant afin de former des bouchons isolants (43) dans lesdits renfoncements,
- réaliser une épitaxie de matériau semi-conducteur (48) à partir d'extrémités dévoilées des couches (10₂, 10₄) à base du deuxième matériau (14), tandis que les couches (10₂, 10₄) à base du premier matériau (12) sont protégées par les bouchons isolants (43).

## Patentansprüche

1. Elektronische Quantenvorrichtung mit einem Substrat (5), wobei das Substrat beschichtet ist mit:
- einer ersten Gruppe von Halbleiterbereichen (102L, 104L), die mindestens einen ersten unteren Halbleiterbereich (102L) und mindestens einen ersten oberen Halbleiterbereich (104L) umfasst, der den ersten unteren Halbleiterbereich überlagert und von diesem durch eine erste "Trennzone" (ZS1) aus dielektrischem Material getrennt ist,
- einer zweiten Gruppe von Halbleiterbereichen (102R, 104R), die mindestens einen zweiten unteren Halbleiterbereich (102R) und mindestens einen zweiten oberen Halbleiterbereich (104R) umfasst, der den zweiten unteren Halbleiterbereich überlagert und von diesem durch eine zweite "Trennzone" (ZS2) aus dielektrischem Material getrennt ist, wobei die ersten und zweiten unteren Halbleiterbereiche (102L, 102R) in derselben ersten Ebene (P1) angeordnet sind, während die ersten und zweiten oberen Halbleiterbereiche (104L, 104R) in derselben zweiten Ebene (P2) angeordnet sind, wobei die ersten und zweiten Ebenen (P1, P2) parallel zu einer Hauptebene des Substrats (5) sind,
wobei die erste Gruppe von Halbleiterbereichen (102L, 104L) gegenüber der zweiten Gruppe von Halbleiterbereichen (102R, 104R) angeordnet ist, so dass der erste untere Halbleiterbereich (102L) gegenüber dem zweiten unteren Halbleiterbereich (102R) angeordnet ist und so dass der erste obere Halbleiterbereich (104L) gegenüber dem zweiten oberen Halbleiterbereich (104R) angeordnet ist,
- mindestens einem dielektrischen Bereich (RD), der die erste Gruppe von Halbleiterbereichen (102R, 104R) von der zweiten Gruppe von Halbleiterbereichen (102R, 104R) trennt,
- eine erste Gruppe von übereinanderliegenden Gittern (GI1, GS1), die mindestens ein erstes unteres Gitter (GI1) und ein erstes oberes Gitter (GS1) umfasst, das das erste untere Gitter überlagert und durch eine erste Isolationszone (ZI1) von diesem getrennt ist, wobei das erste untere Gitter (GI1) und das erste obere Gitter (GS1) jeweils an und gegenüber dem ersten unteren Halbleiterbereich (102L) und dem ersten oberen Halbleiterbereich (104L) angeordnet sind, so dass jeweils eine elektrostatische Steuerung des ersten unteren Halbleiterbereichs und des ersten oberen Halbleiterbereichs ausgeübt wird,
- eine zweite Gruppe von übereinanderliegenden Gittern (GI2, GS2), die mindestens ein zweites unteres Gitter (GI2) umfasst, das von einem zweiten oberen Gitter (GS2) getrennt ist, das das zweite untere Gitter überlagert und von diesem durch eine zweite Isolationszone (ZI2) getrennt ist, wobei das zweite untere Gitter (GI2) und das zweite obere Gitter (GS2) jeweils an und gegenüber dem zweiten unteren Halbleiterbereich (102R) und dem zweiten oberen Halbleiterbereich (104R) angeordnet sind, so dass jeweils eine elektrostatische Steuerung des zweiten unteren Halbleiterbereichs (102R) und des zweiten oberen Halbleiterbereichs (104R) ausgeübt wird, wobei die erste Gruppe von übereinanderliegenden Gittern und die zweite Gruppe von übereinanderliegenden Gittern auf beiden Seiten der ersten Gruppe von Halbleiterbereichen und der zweiten Gruppe von Halbleiterbereichen angeordnet sind,
wobei der dielektrische Bereich (RD), der die erste Gruppe von Halbleiterbereichen (102R, 104R) von der zweiten Gruppe von Halbleiterbereichen (102R, 104R) trennt, so vorgesehen ist, dass eine elektrostatische Kopplung zwischen dem ersten unteren Halbleiterbereich (102L) und dem zweiten unteren Halbleiterbereich (102R) ermöglicht wird, und so, dass eine elektrostatische Kopplung zwischen dem ersten oberen Halbleiterbereich (104L) und dem zweiten oberen Halbleiterbereich (104R) ermöglicht wird.

2. Elektronische Quantenvorrichtung nach Anspruch 1, wobei der erste untere Halbleiterbereich (102L) und der erste obere Halbleiterbereich (104L) jeweils Bereiche eines unteren Halbleiterstabs (102) und eines oberen Halbleiterstabs (104) sind, wobei sich der untere Halbleiterstab und der obere Halbleiterstab parallel zu einer ersten Richtung (y) erstrecken, die parallel zur Hauptebene des Substrats verläuft,
wobei die Vorrichtung eine dritte Gruppe von übereinanderliegenden Gittern (GI3, GS3) neben dieser ersten Gruppe von Gittern (Gl1, GS1) aufweist und wobei die dritte Gruppe von übereinanderliegenden Gittern (GI3, GS3) mindestens ein drittes unteres Gitter (GI3) umfasst, das von einem dritten oberen Gitter (GS3) getrennt ist, das das dritte untere Gitter überlagert und von diesem durch eine dritte Isolationszone getrennt ist, wobei das dritte untere Gitter (GI3) und das dritte obere Gitter (GS3) an und gegenüber jeweils eines dritten unteren Halbleiterbereichs (102L2) des unteren Halbleiterstabs (102) und eines dritten oberen Halbleiterbereichs (104L2) des oberen Halbleiterstabs (104) angeordnet sind, um diese elektrostatisch zu steuern.

3. Elektronische Quantenvorrichtung nach Anspruch 2, wobei der untere Halbleiterstab (102) und der obere Halbleiterstab (104) jeweils ein erster unterer Halbleiterstab und ein erster oberer Halbleiterstab sind, wobei der zweite untere Halbleiterbereich (102R) und der zweite obere Halbleiterbereich (104R) jeweils Bereiche eines zweiten unteren Halbleiterstabs und eines zweiten oberen Halbleiterstabs sind, wobei sich der zweite untere bzw. obere Halbleiterstab parallel zu dem ersten unteren (102) bzw. oberen (104) Halbleiterstab erstreckt, wobei die Vorrichtung mit einer vierten Gruppe (GI4, GS4) von übereinanderliegenden Gittern ausgestattet ist, die neben der zweiten Gruppe von übereinanderliegenden Gittern liegen, zur elektrostatischen Steuerung eines vierten Halbleiterbereichs des zweiten unteren Halbleiterstabs (102) und eines vierten oberen Halbleiterbereichs des zweiten oberen Halbleiterstabs (104), wobei sich der erste untere Halbleiterstab (102) und der zweite untere Halbleiterstab (102') in der ersten Ebene (P1) befinden, wobei sich der erste obere Halbleiterstab und der zweite obere Halbleiterstab in der zweiten Ebene (P2) befinden, wobei der dritte untere Halbleiterbereich gegenüber dem vierten unteren Bereich angeordnet ist, wobei der dritte obere Halbleiterbereich gegenüber dem vierten oberen Halbleiterbereich angeordnet ist.

4. Vorrichtung nach Anspruch 3, weiter umfassend, in einer Richtung parallel zur ersten Richtung (y), zwischen der ersten Gittergruppe (Gl1, GS1) und der dritten Gittergruppe (GI3, GS3):
- mindestens eine Austauschelektrode (GE) oder
- übereinanderliegende und voneinander durch eine isolierende Trennschicht (CSI) getrennte Austauschelektroden (GE11, GE12),
- einen Bereich aus mindestens einem Isoliermaterial (53).

5. Vorrichtung nach einem der Ansprüche 1 bis 4, die Vorrichtung weiter umfassend:
- einen dotierten Halbleiterblock, der ein erstes Dotierstoffreservoir (DT1) bildet, wobei der dotierte Halbleiterblock an einem ersten Ende des ersten oberen Halbleiterstabs, des ersten unteren Halbleiterstabs, des zweiten oberen Halbleiterstabs und des zweiten unteren Halbleiterstabs angeordnet ist,
- einen weiteren dotierten Halbleiterblock, der ein zweites Dotierstoffreservoir (DT2) bildet, wobei der weitere dotierte Halbleiterblock an einem zweiten Ende des ersten oberen Halbleiterstabs, des ersten unteren Halbleiterstabs, des zweiten oberen Halbleiterstabs, des zweiten unteren Halbleiterstabs angeordnet ist und dem ersten Ende gegenübersteht.

6. Vorrichtung nach einem der Ansprüche 1 bis 5, wobei der dielektrische Bereich (RD) zwischen der ersten Gruppe von Halbleiterbereichen (102L, 104L) und der zweiten Gruppe von Halbleiterbereichen (102R, 104R) mit einer heterogenen dielektrischen Zusammensetzung versehen ist, so dass in einem zentralen Abschnitt (244, 303), der sich zwischen dem ersten unteren Halbleiterbereich und dem zweiten oberen Halbleiterbereich und zwischen dem ersten oberen Halbleiterbereich und dem zweiten unteren Halbleiterbereich befindet, der dielektrische Bereich (RD) eine erste Zusammensetzung und eine erste relative Dielektrizitätskonstante aufweist, und dass in einem weiteren Abschnitt (242, 246), der sich zwischen dem ersten unteren Halbleiterbereich und dem zweiten unteren Halbleiterbereich oder zwischen dem ersten oberen Halbleiterbereich und dem zweiten oberen Halbleiterbereich befindet, der dielektrische Bereich (RD) eine zweite Zusammensetzung und eine zweite relative Dielektrizitätskonstante aufweist, die höher ist als die erste relative Dielektrizitätskonstante.

7. Vorrichtung nach einem der Ansprüche 1 bis 6, wobei die Trennzonen (ZS1, ZS2) so vorgesehen sind, dass sie eine elektrostatische Kopplung zwischen dem ersten unteren Halbleiterbereich (102L) und dem ersten oberen Halbleiterbereich (104L) ermöglichen, und so, dass sie eine elektrostatische Kopplung zwischen dem zweiten unteren Halbleiterbereich (102R) und dem zweiten oberen Halbleiterbereich (102L) ermöglichen.

8. Verfahren zur Herstellung einer Quantenvorrichtung nach einem der Ansprüche 1 bis 7, wobei das Bilden der ersten Gruppe von Halbleiterbereichen (102L, 104L) und der zweiten Gruppe (102R, 104R) von Halbleiterbereichen folgende Schritte umfasst:
- Erstellen einer Struktur (16), die aus einer Überlagerung von Schichten (10₁, 10₂, 10₃, 10₄, 10₅) ausgebildet ist, die aus einem Wechsel von Schichten (10₁, 10₃, 10₅) auf Basis eines gegebenen ersten Materials (12) und Schichten (10₂, 10₄) auf Basis eines zweiten Materials zusammengesetzt ist, auf dem Substrat (10), wobei das zweite Material ein Halbleiter ist, wobei das erste gegebene Material dazu geeignet ist, in Bezug auf das zweite gegebene Material selektiv ätzbar zu sein,
- Erstellen eines Trenngrabens (65), der sich hauptsächlich in eine Richtung erstreckt, die parallel zu der ersten Richtung verläuft, durch Ätzen der Überlagerung von Schichten, so dass die Struktur in einen ersten Abschnitt (16A) und einen zweiten Abschnitt (16B) aufgeteilt wird, wobei sich der erste Abschnitt (16A) und der zweite Abschnitt (16B) parallel zu der ersten Richtung erstrecken, wobei die Halbleiterbereiche der ersten Gruppe Halbleiterbereiche des ersten Abschnitts sind und auf Basis des zweiten gegebenen Materials ausgebildet sind, wobei die Halbleiterbereiche der zweiten Gruppe Halbleiterbereiche des zweiten Abschnitts sind und auf Basis des zweiten gegebenen Materials ausgebildet sind.

9. Verfahren zur Herstellung einer Quantenvorrichtung nach Anspruch 8, weiter umfassend, nach dem Erstellen des Grabens (65), das Bilden des dielektrischen Bereichs (RD) durch Ablagerung eines oder mehrerer dielektrischer Materialien (85) zwischen dem ersten Abschnitt (16A) und dem zweiten Abschnitt (16B) der Struktur (16).

10. Verfahren zur Herstellung einer Quantenvorrichtung nach Anspruch 8 oder 9, weiter umfassend, nach dem Erstellen des Trenngrabens und vor dem Bilden des dielektrischen Bereichs (RD), die folgenden Schritte:
- mindestens teilweises Ätzen des ersten gegebenen und gegenüber dem zweiten Material (14) selektiven Materials (12) in den ersten Abschnitt (16A) und den zweiten Abschnitt (16B), so dass Zwischenräume (71) frei werden,
- Füllen der Zwischenräume (71) mit einem dielektrischen Material (73), so dass der erste "Trennbereich" (ZS1) und der zweite "Trennbereich" (ZS2) gebildet werden.

11. Verfahren nach Anspruch 10, weiter umfassend, nachdem die Zwischenräume (71) mit einem bestimmten dielektrischen Material (73) gefüllt wurden, Schritte zum:
- anisotropen Ätzen des dielektrischen Materials, so dass ein Zwischenraum frei wird, der einen reduzierten Graben (75) zwischen den aktiven Bereichsabschnitten (16A, 16B) bildet,
- Füllen des reduzierten Grabens (75) mittels mindestens eines weiteren dielektrischen Materials, das sich vom gegebenen dielektrischen Material unterscheidet.

12. Verfahren nach einem der Ansprüche 8 bis 11, weiter umfassend, nach Bilden der Struktur (16) und vor dem Bilden des Trenngrabens in dieser Struktur (16), Schritte zum:
- Bilden von Gittermustern aus Gittermaterial auf beiden Seiten der Struktur,
- Bilden einer isolierenden Kapselung (52) um die Gittermuster,
- teilweises Entfernen des Gittermaterials, so dass ein unterer Block (GI) aus Gittermaterial erhalten bleibt und Herstellen von Hohlräumen (54) oberhalb dieses unteren Blocks aus Gittermaterial und umgeben von der Kapselung (52),
- Füllen der Hohlräume mit mindestens einer Isolierschicht, so dass eine Isolierzone (ZI) auf dem unteren Block aus Gittermaterial gebildet wird, und
- Füllen der Hohlräume mit mindestens einer Schicht Gittermaterial, so dass sich auf dem Isolationsbereich (ZI) ein oberer Block (GS) aus Gittermaterial bildet.

13. Verfahren zur Herstellung einer Quantenvorrichtung nach einem der Ansprüche 11 oder 12, weiter umfassend,
nach dem Bilden der Struktur (16) und vor dem Bilden des Trenngrabens (65) in dieser Struktur, Bilden von Dotierstoffreservoirs an Enden der Struktur, wobei das Bilden der Dotierstoffreservoirs umfasst:
- Ausführen partiellen selektiven Ätzens des ersten Materials (12) gegenüber dem zweiten Material (14), um Vertiefungen (41) an den Enden der Struktur (16) zu erzeugen,
- Ausfüllen der Vertiefungen (41) mit einem Isoliermaterial, um Isolierstopfen (43) in den Vertiefungen zu bilden,
- Herstellen einer Epitaxie von Halbleitermaterial (48) aus offenen Enden der Schichten (10₂, 10₄) auf Basis des zweiten Materials (14), während die Schichten (10₂, 10₄) auf Basis des ersten Materials (12) durch die Isolierstopfen (43) geschützt sind.

## Claims

1. A quantum electronic device provided with a substrate (5), the substrate being coated with:
- a first set of semiconductor regions (102L, 104L) comprising at least one first lower semiconductor region (102L) and at least one first upper semiconductor region (104L), superimposed on, and separated from, the first lower semiconductor region by means of a first so-called "separation" zone (ZS1), made of dielectric material,
- a second set of semiconductor regions (102R, 104R) comprising at least one second lower semiconductor region (102R) and at least one second upper semiconductor region (104R), superimposed on, and separated from, the second lower semiconductor region by means of a second so-called "separation" zone (ZS2) made of dielectric material, said first and second lower semiconductor regions (102L, 102R) being arranged in a same first plane (P1), whilst said first and second upper semiconductor regions (104L, 104R) are arranged in the same second plane (P2), the first and second planes (P1, P2) being parallel to a main plane of the substrate (5),
the first set of semiconductor regions (102L, 104L) being disposed opposite the second set of semiconductor regions (102R, 104R) such that the first lower semiconductor region (102L) is disposed facing the second lower semiconductor region (102R) and such that the first upper semiconductor region (104L) is disposed facing the second upper semiconductor region (104R),
- at least one dielectric region (RD) separating the first set of semiconductor regions (102R, 104R) from the second set of semiconductor regions (102R, 104R),
- a first group of superimposed gates (Gl1, GS1) comprising at least one first lower gate (Gl1) and one first upper gate (GS1) superimposed on, and separated from, the first lower gate by a first insulation zone (Zl1), the first lower gate (Gl1) and the first upper gate (GS1) being disposed against, and facing, the first lower semiconductor region (102L) and the first upper semiconductor region (104L) respectively so as to exercise electrostatic control of the first lower semiconductor region and the first upper semiconductor region, respectively,
- a second group of superimposed gates (GI2, GS2) comprising at least one second lower gate (GI2) separated from a second upper gate (GS2) superimposed on, and separated from the second lower gate by a second isolation zone (ZI2), the second lower gate (GI2) and the second upper gate (GS2) being disposed against, and facing, the second lower semiconductor region (102R) and the second upper semiconductor region (104R) respectively so as to exercise electrostatic control of the second lower semiconductor region (102R) and the second upper semiconductor region (104R) respectively, the first group of superimposed gates and the second group of superimposed gates being disposed on either side of the first set of semiconductor regions and the second set of semiconductor regions,
said dielectric region (RD) separating the first set of semiconductor regions (102R, 104R) from the second set of semiconductor regions (102R, 104R) being provided so as to allow electrostatic coupling between the first lower semiconductor region (102L) and the second lower semiconductor region (102R), and so as to allow electrostatic coupling between the first upper semiconductor region (104L) and the second upper semiconductor region (104R).

2. The quantum electronic device according to claim 1, wherein the first lower semiconductor region (102L) and the first upper semiconductor region (104L) are regions of a lower semiconductor bar (102) and an upper semiconductor bar (104) respectively, the lower semiconductor bar and the upper semiconductor bar extending in parallel to a first direction (y) parallel to the main plane of the substrate,
the device being provided with a third group of superimposed gates (GI3, GS3) juxtaposed to said first group of gates (Gl1, GS1), and wherein the third group of superimposed gates (GI3, GS3) comprises at least one third lower gate (GI3) separated from a third upper gate (GS3) superimposed on, and separated from the third lower gate by a third isolation zone, the third lower gate (GI3) and the third upper gate (GS3) being disposed against, and facing, a third lower semiconductor region (102L2) of the lower semiconductor bar (102) and a third upper semiconductor region (104L2) of the upper semiconductor bar (104) in order to control them electrostatically.

3. The quantum electronic device according to claim 2, wherein said lower semiconductor bar (102) and said upper semiconductor bar (104), are a first lower semiconductor bar and a first upper semiconductor bar respectively, the second lower semiconductor region (102R) and the second upper semiconductor region (104R) being regions of a second lower semiconductor bar and a second upper semiconductor bar respectively, said second lower and upper semiconductor bars extending in parallel to said first lower (102) and upper (104) semiconductor bars respectively, the device being provided with a fourth group (GI4, GS4) of superimposed gates juxtaposed to said second group of superimposed gates for electrostatic control of a fourth semiconductor region of the second lower semiconductor bar (102) and of a fourth upper semiconductor region of the second upper semiconductor bar (104), the first lower semiconductor bar (102) and the second lower semiconductor bar (102') being located in the first plane (P1), the first upper semiconductor bar and the second upper semiconductor bar being located in the second plane (P2), the third lower semiconductor region being disposed facing the fourth lower region, the third upper semiconductor region being disposed facing the fourth upper semiconductor region.

4. The device according to claim 3, further comprising, in a direction parallel to the first direction (y), between said first group of gates (Gl1, GS1) and said third group of gates (GI3, GS3):
- at least one exchange electrode (GE) or
- superimposed exchange electrodes (GE11, GE12) and separated from each other by an insulating separation layer (CSI),
- a zone of at least one insulating material (53).

5. The device according to any one of claims 1 to 4, wherein the device further comprises:
- a doped semiconductor block, forming a first dopant reservoir (DT1), the doped semiconductor block being arranged at a first end of the first upper semiconductor bar, the first lower semiconductor bar, the second upper semiconductor bar, and the second lower semiconductor bar,
- another doped semiconductor block, forming a second dopant reservoir (DT2), the other doped semiconductor block being arranged at a second end of the first upper semiconductor bar, the first lower semiconductor bar, the second upper semiconductor bar, the second lower semiconductor bar, and which is opposite to the first end.

6. The device according to one of claims 1 to 5, wherein the dielectric region (RD) between the first set of semiconductor regions (102L, 104L) and the second set of semiconductor regions (102R, 104R) is provided with a heterogeneous dielectric composition such that in a central portion (244, 303) located between the first lower semiconductor region and the second upper semiconductor region and between the first upper semiconductor region and the second lower semiconductor region, the dielectric region (RD) has a first composition and a first relative dielectric permittivity, and that in another portion (242, 246) located between the first lower semiconductor region and the second lower semiconductor region or between the first upper semiconductor region and the second upper semiconductor region, the dielectric region (RD) has a second composition and a second relative dielectric permittivity higher than the first relative dielectric permittivity.

7. The device according to one of claims 1 to 6, said separation zones (ZS1, ZS2) being provided so as to allow electrostatic coupling between the first lower semiconductor region (102L) and the first upper semiconductor region (104L), and so as to allow electrostatic coupling between the second lower semiconductor region (102R) and the second upper semiconductor region (102L).

8. A method for manufacturing a quantum device according to one of claims 1 to 7, wherein forming the first set of semiconductor regions (102L, 104L) and said second set (102R, 104R) of semiconductor regions comprises steps of:
- making on said substrate (10) a structure (16) formed of a superposition of layers (10₁, 10₂, 10₃, 10₄, 10₅ ) composed of an alternation of layers (10₁, 10₃, 10₅ ) based on a given first material (12), and layers (10₂, 10₄ ) based on a second material, the second material being semiconductor, said first given material being able to be etched selectively with respect to said second given material,
- making a separation trench (65) mainly extending in a direction parallel to the first direction by etching said superposition of layers so as to divide said structure into a first portion (16A) and a second portion (16B), the first portion (16A) and the second portion (16B) extending in parallel to the first direction, the semiconductor regions of said first set being semiconductor regions of the first portion and formed from said second given material, the semiconductor regions of said second set being semiconductor regions of the second portion and formed from said second given material.

9. The method for manufacturing a quantum device according to claim 8, further comprising, after making said trench (65), forming said dielectric region (RD) by depositing one or more dielectric materials (85) between said first portion (16A) and said second portion (16B) of said structure (16).

10. The method for manufacturing a quantum device according to claim 8 or 9, further comprising, after making the separation trench and prior to forming said dielectric region (RD), steps of:
- etching at least partially said given first material (12) and selectively with respect to the second material (14) in the first portion (16A) and said second portion (16B) so as to free spaces (71),
- filling said spaces (71) with a dielectric material (73) so as to form the first "separation" zone (ZS1) and the second "separation" zone (ZS2).

11. The method according to claim 10, further comprising, after filling said spaces (71) with a given dielectric material (73), steps of:
- anisotropically etching the dielectric material so as to free a space forming a narrow trench (75) between said active zone portions (16A, 16B),
- filling the reduced trench (75) by means of at least one other dielectric material different from said given dielectric material.

12. The method according to one of claims 8 to 11, further comprising, after forming said structure (16) and prior to forming said separation trench in this structure (16), steps of:
- forming gate patterns of gate material on either side of the structure,
- forming an insulating encapsulation (52) around the gate patterns,
- partially removing the gate material so as to keep a lower block (GI) of gate material and make cavities (54) above this lower block of gate material and surrounded by the encapsulation (52),
- filling the cavities with at least one insulating layer so as to form an insulation zone (ZI) on the lower block of gate material and then,
- filling the cavities with at least one layer of gate material, so as to form an upper block (GS) of gate material on the insulation zone (ZI).

13. The method for manufacturing a quantum device according to any one of claims 11 or 12, further comprising,
after forming said structure (16) and prior to forming said separation trench (65) in said structure, forming dopant reservoirs at ends of said structure, forming said dopant reservoirs comprising:
- performing a partial selective etching of the first material (12) with respect to the second material (14) in order to create recesses (41) at said ends of said structure (16),
- filling said recesses (41) with an insulating material so as to form insulating plugs (43) in said recesses,
- performing epitaxy of a semiconductor material (48) from exposed ends of the layers (10₂, 10₄) based on the second material (14), whilst the layers (10₂, 10₄) based on the first material (12) are protected by the insulating plugs (43).
